# EUROPÄISCHE PATENTSCHRIFT

(11) **EP 2 385 545 B1**
(45) Veröffentlichungstag und Bekanntmachung des Hinweises auf die Patenterteilung: **02.03.2016**
(21) Anmeldenummer: 11176310.8
(22) Anmeldetag: 07.11.2008
(51) Int. Cl.: H01L 21/66, B23K 20/00, H01L 21/607

(54) **Verfahren und Vorrichtung zum Ultraschallbonden**
Method and apparatus for ultrasonic bonding
Procédé et dispositif de soudage par ultrasons

(30) Priorität: 12.11.2007 DE 102007054626
(43) Veröffentlichungstag der Anmeldung: 09.11.2011
(62) Teilanmeldung aus: 08850453.5
(73) Patentinhaber: Hesse GmbH, 33100 Paderborn (DE)
(72) Erfinder: Hesse, Hans-Jürgen, 33106 Paderborn (DE); Brökelmann, Michael, 33129 Delbrück (DE); Hagenkötter, Sebastian, 33098 Paderborn (DE)
(74) Vertreter: Wickord, Wiro

(56) Entgegenhaltungen:
- EP-A- 0 275 877
- EP-A1- 1 897 648
- EP-A2- 0 247 291
- WO-A-99/19107
- WO-A-02/070185
- WO-A-2006/032316
- DE-A1- 3 429 776
- US-A- 3 458 921
- US-A- 4 998 664
- DONG ZHANG ET AL: "Monitoring wire bonding via time-frequency analysis of horn vibration", IEEE TRANSACTIONS ON ELECTRONICS PACKAGING MANUFACTURING, IEEE, PISCATAWAY, NY, US, Bd. 26, Nr. 3, 1. Juli 2003 (2003-07-01), Seiten 216-220, XP011105046, ISSN: 1521-334X, DOI: 10.1109/TEPM.2003.820800
- BROKELMANN M ET AL: "Bond process monitoring via self-sensing piezoelectric transducers", FREQUENCY CONTROL SYMPOSIUM AND EXPOSITION, 2004. PROCEEDINGS OF THE 2 004 IEEE INTERNATIONAL MONTREAL, CANADA 23-27 AUG. 2004, PISCATAWAY, NJ, USA,IEEE, 23. August 2004 (2004-08-23), Seiten 125-129, XP010784600, ISBN: 978-0-7803-8414-9
- BROKELMANN M ET AL: "Model based development of an integrated sensor-actuator system for online quality monitoring in ultrasonic wire bonding", AD / AEROSPACE DIVISION, AMERICAN SOCIETY OF MECHANICAL ENGINEERS; 2005 ASME INTERNATIONAL MECHANICAL ENGINEERING CONGRESS AND EXPOSITION, IMECE 2005, AMERICAN SOCIETY OF MECHANICAL ENGINEERS / AEROSPACE DIVISION, US; ORLANDO, FL, USA, Bd. 70AD, 1. Januar 2005 (2005-01-01), Seiten 219-226, XP008149932, ISSN: 0733-4230
- WANG QIWEN ET AL: "Neural network model for the wire bonding process", COMPUTERS AND OPERATIONS RESEARCH, OXFORD, GB, Bd. 20, Nr. 8, 1. Oktober 1993 (1993-10-01), Seiten 879-888, XP008149894, ISSN: 0305-0548, DOI: 10.1016/0305-0548(93)90108-U [gefunden am 2003-05-20]

## Beschreibung

Die Erfindung betrifft ein Verfahren nach dem Oberbegriff des Patentanspruchs 1. Ferner betrifft die Erfindung eine Bondvorrichtung nach dem Oberbegriff des Patentanspruchs 8.

Das Wedge-Wedge-Bonden ist eine allgemein anerkannte und zuverlässige Technik zur Kontaktierung von Chip und Substrat. Es wird sowohl in der Leistungselektronik als auch in der Mikroelektronik eingesetzt. Zur Überwachung der Qualität des Bondprozesses wird aus der laufenden Produktion ein bestimmter Prozentsatz der Produkte einem zerstörenden Test unterzogen und mit statistischen Verfahren auf die Qualität des gesamten Fertigungsloses geschlossen.

Der Wunsch einer weitergehenden Qualitätskontrolle insbesondere in sicherheitsrelevanten Bereichen hat dazu geführt, dass in den letzten Jahren mehrere Verfahren entwickelt wurden, die ergänzend zu dem oben angeführten zerstörenden Test eine Inline-Überwachung ermöglichen. Zu erwähnen sind im wesentlichen zwei Methoden, zum Einen die nicht zerstörende mechanische Überprüfung einer Bondverbindung, bei der geringe Kräfte auf die Verbindung wirken (Zug- oder Scherkräfte), um ihre Festigkeit zu überprüfen, zum Anderen eine auf der Messung von Signalen, die unmittelbar aus dem Ultraschallgenerator oder dem Lagegeber des Transducers gewonnen werden können, beruhende Methode.

Die zweite Methode verwendet als Messgrößen den in den Transducer fließenden Strom, die Spannung am Ausgang des Ultraschallgenerators oder die Verformung des Drahtes oder eine Kombination aus diesen Größen.

Als Stellgrößen für die Festlegung eines Prozessfensters dienen die Bondkraft, die Ultraschallleistung sowie die Bondzeit. Diese Verfahren werden beschrieben in den Patenten US 4,606,490, EP 0 368 533 B1, EP 0 540189 B1. Wesentliches Merkmal dieser Verfahren ist, dass die gemessenen Größen relativ zu einer durch den Benutzer vorgegebenen Kennlinie verlaufen. Ein Schwachpunkt dieser Methode besteht darin, dass auch schlechte Bondverbindungen derartige Verformungs- und Stromverläufe zeigen können. Damit ist die angegebene Regel allenfalls notwendig, auf keinen Fall aber hinreichend zur Bestimmung der Bondqualität, mithin ungeeignet, einen qualitativ minderwertigen Bond mit Sicherheit zu erkennen.

Ein Versuch, diesen Mangel auszugleichen, findet sich in den Patentschriften EP 1023 139 B1 und EP 1 342 201. In den älteren Verfahren wurde lediglich eine Messgröße betrachtet und als Qualitätsmaß zugrunde gelegt. Inden neuen Verfahren wird versucht, eine Verknüpfung der vorgenannten Größen vorzunehmen und daraus Qualitätskriterien abzuleiten. Anstelle des Stromes wird hier die elektrische Admittanz des Transducers als eine von der Ultraschallleistung weitestgehend unabhängige Größe verwendet. Aus der Kombination von Ad- mittanzverlauf und Drahtverformung und deren Korrelation wird versucht, eine zuverlässigere Aussage über die Verbindungsqualität zu erlangen.

Auch diese Verfahren führen nicht zum Ziel, da die verwendeten Messgrößen nicht hinreichend mit den in der Verbindungszone stattfindenden physikalischen Vorgängen korrelieren. So entspricht beispielsweise die elektrische Resonanz (Phasenwinkel zwischen Strom und Spannung = Null) nicht der mechanschen Resonanz (Phasenwinkel zwischen Geschwindigkeit der Werkzeugspitze und der Spannung =Null), so dass Systeme, die nur die elektrischen Größen verwenden, nicht in mechanischer Resonanz betrieben werden. Weder die Geschwindigkeit der Werkzeugspitze noch die Reibung zwischen den Verbindungspartnern, also die physikalischen Größen, die unmittelbar für die Verbindungsbildung von entscheidender Bedeutung sind, werden mit den vorerwähnten Verfahren erfasst.

Die Verwendung eines in der Membran montierten Sensors ist in EP 1 789 226 Al bzw. WO 2006/032316 A1 der Anmelderin beschrieben.

Aus der WO 02/070185 A1, die als nächstliegender Stand der Technik angesehen werden kann, ist ein Verfahren zur Prüfung von Verbindungsstellen bekannt, welche durch Ultraschall-Drahtbonden hergestellt sind. Es wird hierzu während des Bondvorgangs der zeitliche Verlauf von Bondparametern, namentlich die Drahtdeformation sowie der zeitliche Verlauf der Bondkeilamplitude ermittelt. Die Bondparameter werden mit gespeicherten Referenzparametern verglichen. Auf Basis des Vergleichs wird ein Maß in Bezug auf die Bondqualität ermittelt.

Ein Verfahren zur Überwachung des Bondprozesses ist auch aus dem Tagungsbeitrag "Bond Process Monitoring via Self-Sensing Piezoelectric Transducers" (Brökelmann at all, Frequency Control Symposium and Exposition, 2004, Proceedings of the 2004 IEEE International Ultrasonics, Ferroelectrics, and Frequency Control Joint 50th Anniversary Conference, Seiten 125 - 129, ISBN: 978-0-7803-8414-9) bekannt. Es wird hierbei insbesondere vorgeschlagen, den Spannungs- und Stromverlauf am elektrischen Anschluss des Transducers zu überwachen, um auf dieser Basis unmittelbar aus dem Strom und die Qualität zu schließen oder über einen elektromechanisches Ersatzmodell und die Schwingungsamplitude an der Wedge-spitze auf die Qualität zu schließen.

Die beschriebenen, bisher bekannt gewordenen Verfahren sind also nicht geeignet, die für die Beurteilung der Verbindungsqualität wesentlichen Daten zu erfassen und entsprechend zu verarbeiten. Insoweit können diese Verfahren die Anforderungen der Qualitätsüberwachung in vollautomatischen Bondern nicht erfüllen.

Die Erfindung betrifft ein Verfahren zur Qualitätskontrolle beim Ultraschall-Bonden, insbesondere Ultraschall-Drahtbonden, bei welchem eine Transducer-Bondwerkzeug-Einheit und ein Ultraschall-Generator verwendet werden und bei dem während des Bondens Messsignale von einem oder mehreren, während des Bondens variablen Parametern, insbesondere zur Beurteilung der Bondqualitätund/oder zur Beeinflussung des Bondens, erfasst werden.

Ausgehend von dem beschriebenen Stand der Technik liegt der Erfindung die Aufgabe zugrunde, Verfahren der genannten Art vorteilhaft weiterzubilden, so dass insbesondere eine genauere und zuverlässigere Beurteilung der Bondqualität ermöglicht wird.

Zur Lösung der Aufgabe weist das erfindungsgemäße Verfahren die Merkmale des Patentanspruchs 1 auf. Die erfindungsgemäße Vorrichtung weist die Merkmale des Patentanspruchs 8 auf.

Die Ermittlung von Einzel-Qualitätsindices Qi, die im Rahmen der Erfindung auch als Merkmals-Extraktion (vgl. auch die Figuren) bezeichnet wird, ermöglicht in besonders übersichtlicher und aussagekräftiger Weise die Überwachung der Bondqualität und sogar, wie auch nachfolgend erläutert, die weitere Verwendung zur Steuerung und/oder Regelung des Herstellungsverfahrens von Bondverbindungen (d.h. des sog. Bondens). Dabei ist im Rahmen der Erfindung eine Mehrgrößen-Betrachtung bzw. Überwachung bevorzugt.

Die Ist-Verläufe, Soll-Verläufe und Abweichungs-Verläufe können grundsätzlich bzw. allgemein, d. h. auch im Zusammenhang mit den anderen Aspekten der Erfindung wieder beispielsweise eindimensionale Vektoren bzw. Wertefolgen mit vorzugsweise in der zeitlichen Reihenfolge der zugrundeliegenden Messsignale sortierten Werten sein. Insofern kann auch begrifflich von Vektoren (Merkmalsvektoren) anstelle von Verläufen gesprochen werden, also von Ist-Vektoren, Soll-Vektoren, Abweichungs-Vektoren usw.. Sie können vereinfacht als Wertekolonnen verstanden werden, wobei die Anzahl ihrer Zahlenwerte unter anderem von der bei den Messungen verwendeten Taktrate und der Dauer der Bondvorgänge bzw. Messungen abhängt. Dabei ist bevorzugt, dass Ist-Vektoren und Soll-Vektoren die gleiche Dimension bzw. Länge aufweisen, so dass in besonders anschaulicher Weise jeweils Paare aus Werten beider Vektoren, die einander in der Schrittfolge bzw. im Messzeitpunkt (also zeitlich) zugeordnet sind, zur Erzeugung von Werten des Abweichungsvektors ausgewertet werden können.

Wie zuvor beschrieben, schlägt die Erfindung die Generierung von Merkmalsverläufen bzw. Merkmalsvektoren aus gemessenen und/oder abgeleiteten Größen vor. Bei der Berechnung eines Einzel-Qualitätsindex Qi wird der zugrunde liegende Merkmalsvektor bzw. dessen Abweichungs-Vektor vorzugsweise eine skalare Größe umgewandelt. Bezeichnet man die Anzahl der bei der Qualitätsberechnung zugrundeliegenden Merkmals-Vektoren bzw. Verläufe mit n, handelt es sich dabei um eine Abbildung von n Merkmalsvektoren, welche gleiche oder unterschiedliche Dimensionen aufweisen können, auf einen Merkmals-Vektor (Ergebnis-Vektor) der Dimension n. Vorzugsweise kann dabei jedes Element des Ergebnis-Vektors als skalare Größe dem mathematischen Betrag des jeweils zugrunde liegenden Merkmals-Vektors entsprechen.

Bevorzugt ist vorgesehen, dass bei der Berechnung des Qualitätsindex Q zumindest einzelne der Qualitätsindices Qi beziehungsweise der Abweichungsverläufe, insbesondere gemäß zuvor in einem Speicher abgelegter Informationen, individuell und insbesondere voneinander unabhängig gewichtet werden. Die Genauigkeit der Qualitätsbeurteilung lässt sich insbesondere auch noch dadurch steigern, dass bei der Berechnung ein oder mehrere Abweichungs-Verläufe zeitlich bzw. in ihrem Verlauf (d.h. bezüglich der verschiedenen Elemente des Abweichungs-Vektors) veränderlich gewichtet werden. Bevorzugt kann das erfindungsgemäße Verfahren so ausgeführt werden, dass mittels geeigneter Rechenmittel aus einzelnen Abweichungsverläufen jeweils ein Einzel-Qualitätsindex Qi, insbesondere unter individueller zeitlicher bzw. verlaufsmäßiger Gewichtung,gemäß abgespeicherten Informationen ermittelt wird und dass der Qualitätsindex Q aus mehreren Einzelqualitätsindices Qi gemäß einem abgespeicherten Algorithmus berechnet wird.

Diesen Verfahrensschritten liegt die nun gefundene Erkenntnis zugrunde, dass verschiedenen Bondparametern (oder daraus abgeleiteten Größen) bzw. deren gemessenen Zeitverläufen bei der Beurteilung der Bondqualität untereinander und auch einzelnen Bondparametern (oder daraus abgeleiteten Größen) innerhalb verschiedener Zeitintervalle eines Bondvorganges eine unterschiedlich starke Bedeutung zukommen kann. Dies bedeutet, dass für eine genaue Qualitätsbewertung ein Modell, welches nur einzelne, als wesentlich angenommene Bondparameter berücksichtigt, diese aber dafür über die gesamte Bonddauer, oder ein Modell, welches prinzipiell alle messtechnisch erfassten Parameter ständig berücksichtigt, je nach Bedingungen des Bondprozesses und den hierauf einwirkenden Störeinflüssen nicht ausreichend sein kann. Das Verfahren ermöglicht es nun, gefundene Erkenntnisse darüber, welche Bondparameter in welchen Zeiträumen innerhalb der Bonddauer eine größere oder kleinere Bedeutung haben können, in ein automatisiertes Verfahren zur Qualitätskontrolle bzw. in eine zu dessen Ausführung geeignete Bondvorrichtung zu integrieren. Entsprechende Erkenntnisse und Zusammenhänge können in Versuchen ermittelt und dann bspw. in einer Datenbank, einem Expertensystem oder dergleichen archiviert werden. Sollen später unter entsprechenden Bondbedingungen, d. h. für das gleiche Referenzsystem, Bondverbindungen hergestellt werden, können die archivierten Informationen in einen Arbeitsspeicher geladen werden, so dass eine insofern maßgeschneiderte Qualitätsbeurteilung möglich ist. So kann es unter bestimmten Voraussetzungen beispielsweise vorteilhaft sein, dem zeitlichen Verlauf derDrahtverformung gegen Ende eines Bondvorganges eine größere Bedeutung beizumessen. Ebenso wäre beispielsweise denkbar, einem die veränderliche Reibung repräsentierenden Verlauf in einem frühen Zeitintervall des Bondabschnittes eine im Vergleich zu einem späteren Zeitabschnitt größere Gewichtung beizumessen. Natürlich besteht auch die Möglichkeit, bei Bedarf bestimmte Bondparameter mit über die Bonddauer gleicher Gewichtung zu versehen. Entscheidend ist die Möglichkeit, dass verschiedene Bondparameter individuell und insofern voneinander unabhängig gewichtet werden können. Analog besteht auch die Möglichkeit, die individuelle Gewichtung von Bondparametern im Rahmen einer in Echtzeit arbeitenden Steuerung oder Regelung des Bondprozesses zur Beeinflussung von Stellgrößen einzusetzen. Beispielsweise wäre denkbar, dass die Ultraschallleistung am Anfang eines Bondvorganges unter stärkerer Gewichtung eines ersten Bondparameters und gegen Ende des Bondvorganges unter stärkerer Gewichtung eines Soll-Ist-Vergleichs für einen anderen Bondparameter beeinflusst wird.

Das Verfahren schließt nach dem Vorangehenden auch die Möglichkeit mit ein, dass Abweichungsverläufe einzelner Bond-Parameter zu- folge ihrer individuellen Gewichtung nur zu bestimmten Zeitintervallen innerhalb von Bondvorgängen wertemäßig berücksichtigt werden. Dies lässt sich beispielsweise dadurch erreichen, dass diesen Parametern in anderen Zeitabschnitten des Bondvorganges die Gewichtung Null zugeordnet wird. Während auch hier die Erfassung der grundsätzlich berücksichtigten Bondparameter laufend während der Bonddauer erfolgt, kann die Gewichtung einzelner Bondparameter bei der Qualitätsbeurteilung während verschiedener Zeitintervalle unterschiedlich sein. Neben der Vorgabe der verschiedenen Gewichtungen selbst kann auch die Möglichkeit gegeben sein, die Anfangs- und Endpunkte für die verschiedenen Parameter individuell vorzugeben. Alternativ oder kombinativ zu sprunghaften Veränderungen der Gewichtung von Parametern können auch Gewichtungsfunktionen vorgegeben werden, bei denen sich der Gewichtungsfaktor in kleinen Schritten bzw. quasi kontinuierlich ändert. Möglich wäre dies bspw. durch die Vorgabe von Gewichtungsvektoren.

Es besteht auch, wie schon angesprochen, die Möglichkeit, dass aus Messsignalen verschiedener Parameter insbesondere mittels geeigneter Rechenmittel abgeleitete Größen gebildet und aus deren jeweiligen Ist-Verläufen durch rechnerischen Vergleich mit zuvor abgespeicherten Soll-Verläufen dieser abgeleiteten Größen wiederum Abweichungs-Verläufe ermittelt werden und dass diese Abweichungsverläufe zur zeitlich individuell gewichteten Ermittlung eines Qualitätsindex verwendet werden. Der Begriff Vergleich ist hier wie im Vorangehenden im Sinne der vielfältigen Möglichkeiten der Datenverarbeitung bzw. Rechenoperationen weit zu verstehen. In einem einfachen Beispiel könnte der Vergleich in einer einfachen Subtraktion bzw. Differenzbildung von Soll-Ist-Wertepaaren bestehen, es wären aber auch andere Algorithmen vorstellbar. Betreffend die bspw. durch Vektoren vorgegebenen Soll-Verläufe besteht die Möglichkeit, dass diese bspw. in einem Speicher fest vorgegeben sind (bspw. aus einem Expertensystem stammen) oder zuvor in einer Lernphase, vorzugsweise gemäß oder analog zu nachfolgend beschriebenen Merkmalen, ermittelt wurden. Auch besteht die Möglichkeit, dass Messsignale, welche die Werkzeug-Geschwindigkeit des Ultraschallwerkzeugs in dessen Schwingungsrichtung repräsentieren, gemäß einem oder mehreren der Ansprüche 1 bis 14 gemäß der am internationalen Anmeldetag eingereichten Fassung ermittelt werden, wozu auch auf die diesbezüglich vorrangehende Beschreibung bezuggenommen wird. Zur Automatisierung des zuvor beschriebenen Verfahrens ist auch bevorzugt, dass zumindest einzelne oder mehrere seiner Schritte mittels Software rechnergestützt durchgeführt werden. Eine bevorzugte Weiterbildung wird auch in der Möglichkeit gesehen, die ermittelten Einzelqualitätsindices oder den gesamten Qualitätsindex zur Verfeinerung der Steuerung und/oder Regelung des weiteren Bondbetriebs einzusetzen. Bevorzugt ist, dass eine oder mehrere, insbesondere voneinander unabhängig gewichtete und/oder zeitlich gewichtete Abweichungs-Verläufe und/oder ein oder mehrere Qualitätsindices Qi und/oder der Qualitätsindex Q zur Steuerung oder Regelung eines gerade laufenden und/oder nachfolgender Bondvorgänge verwendet werden. Stellgrößen können auch hier vorzugsweise die Bondkraft, die Ultraschalleistung sowie die Bondzeit sein.

Zu möglichen bevorzugten Weiterbildungen der erfindungsgemäßen Bondvorrichtung wird auch Bezug auf die Merkmale der Ansprüche 26 bis 31 gemäß der am internationalen Anmeldetag eingereichten Fassung und zu möglichen Wirkungen und Vorteilen Bezug auf die gesamte Beschreibung genommen. Wie in den genannten Ansprüchen 26 bis 31 angegeben, besteht die Möglichkeit,

dass die Berechnungseinheit mit einem Speicher, insbesondere mit dem besagten Speicher, in Verbindung steht und Einzel-Qualitätsindices Qi und/oder den Qualitätsindex Q an den Speicher sendet. Es besteht auch die Möglichkeit, dass die Bewertungseinheit Mittel aufweist zur verlaufsmäßigen Gewichtung der Abweichungs-Verläufe bei der Berechnung der Einzel-Qualitätsindices Qi. Auch kann vorgesehen sein, dass die Berechnungseinheit Mittel aufweist zur individuellen bzw. voneinander unabhängigen Gewichtung der Einzel-Qualitätsindices Qi bei der Berechnung des Qualitätsindex Q. Die Bondvorrichtung kann Merkmale gemäß einem oder mehreren der Ansprüche 9 bis 14 gemäß der am internationalen Anmeldetag eingereichten Fassung aufweisen, wozu auch auf die diesbezügliche vorangehende Beschreibung Bezug genommen wird. Es besteht auch die Möglichkeit, dass die Bondvorrichtung eine Steuerungseinrichtung oder eine Regelungseinrichtung zur Steuerung bzw. Regelung des Bondprozesses aufweist, dass die Bewertungseinheit und/oder die Berechnungseinheit mit der Steuerungs- bzw. der Regelungseinrichtung der Bondvorrichtung zur Übertragung von Daten, insbesondere von unabhängig voneinander und/oder zeitlich gewichteten Abweichungsverläufen und/oder von Einzel-Qualitätsindices Qi und/oder dem Qualitätsindex Q, verbunden ist, und dass die Steuerungs- bzw. die Regelungseinheit die übertragenen Daten zur Steuerung bzw. Regelung des Bondprozesses, vorzugsweise zur Beeinflussung der Bondkraft und/oder der Ultraschallleistung und/oder der Bondzeit als Stellgrößen, verwendet. Bezüglich der genannten Ansprüche besteht auch die Möglichkeit, dass die Bondvorrichtung zumindest einen Rechner, insbesondere einen PC, aufweist, welcher mit der Signalverarbeitungseinheit und/oder der Bewertungseinheit und/oder der Berechnungseinheit und/oder dem besagten Speicher zur Ausführung eines Bondverfahrens gemäß einem oder mehreren der Verfahrensansprüche gemäß der am internationalen Anmeldetag eingereichten Fassung verbunden ist oder einzelne oder mehrere dieser Komponenten beinhaltet. Die Messgrößen bzw. Parameter, wie Strom, Drahtverformung, Resonanzfrequenz, Wedgegeschwindigkeit, Phasendifferenzen aus Ultraschallspannung und -strom bzw. Wedgegeschwindigkeit und Spannung, sowie die aus den Sensorsignalen abgeleiteten Größen, bspw. Admittanz bzw. Impedanz und Reibung, werden mit einem vorgegebenen oder gelernten zeitlichen Verlauf (Sollverlauf) verglichen. Aus der Abweichung der einzelnen Messgrößen von der zugehörigen Sollkurve bzw. Soll-Verlauf wird eine gewichtete Eingangsgröße für die nachfolgende Berechnung des Qualitätsindex bestimmt. Die Gewichtung der einzelnen Werte und der Zeitraum, in dem diese Werte betrachtet werden, sind einstellbar.

Vor dem Hintergrund der eingangs zum Stand der Technik erläuterten Schwierigkeiten liegt einer ersten Weiterbildung der Erfindung die zusätzliche Aufgabe zugrunde, verbesserte Möglichkeiten zur Qualitätskontrolle bereit zu stellen, insbesondere weitere, für die Verbindungsbildung wesentliche bzw. aussagekräftige physikalische Größen darin einzubeziehen.

Es sind beispielsweise die Geschwindigkeit der Wedge-Spitze und die Reibung zwischen den Verbindungspartnern für die Verbindungsbildung wesentliche und insofern für die Beurteilung des Bondvorganges aussagekräftige physikalische Größen bzw. Parameter des Bondprozesses. Diese sollen daher aus einem Sensorsignal extrahiert und einer Bewertungseinheit zur Verfügung gestellt werden. Dieser Bewertungseinheit kann dann ein geeignetes Modell als Referenz zugrunde liegen, auf dessen Basis die Bewertung der Prozessdaten möglich ist.

Beispielsweise wird während des Bondens zumindest ein den Zeit-Geschwindigkeits-Verlauf der Spitze des Ultraschallwerkzeuges in deren Schwingungsrichtung, insbesondere qualitativ oder bezüglich des Phasenverlaufes, repräsentierendes Geschwindigkeits-Verlauf-Messsignal erfasst. Insofern stellt der Zeit-Geschwindigkeits-Verlauf der Werkzeug- bzw. Wedge-Spitze einen Parameter (Bondparameter) dar, der als Messgröße bzw. als variable Größe des Bondvorganges dessen Beobachtung erlaubt. Die davon erzeugten Messsignale können als Eingangsgrößen für eine nachfolgende Auswertung, insbesondere zur Beurteilung der Bondqualität, und/oder zur Steuerung und/ oder Regelung des gerade aktuellen und/oder nachfolgender Bondvorgänge verwendet werden. Es besteht die Möglichkeit, dass ergänzend einzelne oder mehrere weitere Eingangssignale aus unterschiedlichen Quellen mit einbezogen werden. In Betracht kommen alle prozessrelevanten Größen, beispielsweise aus der Kinematik die Drahtverformung, aus dem Ultraschallsystem die Frequenz, die Phasendifferenz zwischen Strom und Spannung sowie der Ultraschallstrom und aus zusätzlichen Sensoren beispielsweise die mechanische Ultraschallschwingung und die Phase zwischen Wedgegeschwindigkeit und Ultraschallstrom. Die Erfassung der Parameter bzw. Messgrößen kann kontinuierlich oder quasi kontinuierlich bzw. bei einer geeigneten Taktrate aufgenommen werden. Die dabei für eine jeweilige Messgröße während der Herstellung einer Bondverbindung, d. h. während eines Bondvorganges, ermittelten Zahlenwerte können als Wertekolonne zu einem Vektor (Merkmalsvektor) zusammengefasst werden, der für die weitere Auswertung und Verwendung zur Verfügung steht. Die dabei in einem Zeitintervall aufgenommen und ggf. zu einem Vektor zusammengefassten Werte werden nachfolgend in ihrer zeitlichen Reihenfolge auch als Verläufe bezeichnet. Als zweckmäßig wird angesehen, wenn die Erfassung bzw. Auflösung des Zeit-Geschwindigkeits-Verlaufes der Werkzeugspitze in deren Schwingungsrichtung in so feinen zeitlichen Schritten erfolgt, dass dabei der im allgemeinen aus Sinus- und/oder Kosinus-Anteilen zusammengesetzte zeitliche Verlauf abgebildet wird. Eine insofern eindeutige Erfassung kann für diese und bei Bedarf für weitere Messgrößen in Echtzeit erfolgen, vorzugsweise unter

Verwendung einer FPGA-basierten Elektronik, welche sich über eine zusätzliche

Schnittstelle an einen DDS- Ultraschallgenerator anschließen lässt. Auch besteht die Möglichkeit, aus einzelnen oder mehreren der vorgenannten, zu Messgrößen bzw. Bondparametern ermittelten Signalen weitere prozessrelevante Größen abzuleiten. Insbesondere besteht die Möglichkeit, unter Verwendung der von dem Geschwindigkeitsverlauf der Werkzeugspitze ermittelten Sensorsignale abgeleitete Größen zu gewinnen, welche der Reibung zwischen der Werkzeug- bzw. Wedge-Spitze und dem Draht, die Reibung zwischen Draht und Substrat, die Ankopplung vom Draht an das Substrat, die Werkzeug- bzw. Wedgespitzenauslenkung bzw. -geschwindigkeit zugeordnet sind bzw. dies repräsentieren, Die Erzeugung abgeleiteter Signale aus Messsignalen kann beispielsweise durch Bearbeitung, insbesondere Transformation, von einzelnen oder mehreren Messsignalen (beispielsweise auch Filterung) und/oder durch rechnerische Verknüpfung von mehreren (beispielsweise zwei, drei usw.) Messsignalen durchgeführt werden. Beispielsweise kommt als abgeleitete Größe auch die mechanische Admittanz als Quotient der beiden Messgrößen Werkzeuggeschwindigkeit und Generatorspannung in Betracht. Weitere Beispiele sind die elektrische Admittanz als Quotient aus Strom und Spannung des Generators sowie die elektrische Impedanz als Kehrwert der Admittanz.

Des Weiteren stellen auf Ähnlichkeitsfunktionen (Texturvergleiche) basierende Größen weitere mögliche Eingangsgrößen, insbesondere auch für die Berechnung eines Qualitätsindex, insbesondere gemäß weiteren Aspekten der Erfindung, dar. Jede dieser Eingangsgrößen stellt einen Vektor dar, dessen Länge von der Aufzeichnungsdauer, der Abtastrate und ggf. angewandten Vorverarbeitungsoperationen abhängig ist.

Beispielsweise wird das Geschwindigkeits-Verlauf-Messsignal mittels eines Piezosensors aufgenommen, der vorzugsweise in/an einer Lagerung des Ultraschall-Transducers angeordnet ist und mittels dem insbesondere eine Querdehnung senkrecht zu einer sich ausbreitenden anregenden Ultraschallwelle messtechnisch erfassbar ist. Zu diesem Zweck kann vorzugsweise ein Piezosensor verwendet werden, wie dieser in der WO 2006/032316 A1 der Anmelderin beschrieben ist. Untersuchungen mit einem solchen Sensor haben überraschend ergeben, dass die zu Vergleichszwecken mit einem Laserinterferometer gemessene Geschwindigkeit der Werkzeug-bzw. Wedge-Spitze mit der Sensorspannung bzgl. der Phasenlage übereinstimmt. Ausgehend von dieser Erkenntnis wird gemäß einer Weiterbildung des erfindungsgemäßen Verfahrens vorgeschlagen, dass der dem Ultraschall-Transducer von dem Ultraschall-Generator zugeleitete Zeit-Generatorspannungs-Verlauf gemessen, dass dies beispielsweise mittels eines Phasen-Komparators die Phasendifferenz zwischen dem Zeit- Generatorspannungs-Verlauf und dem Geschwindigkeits-Verlauf-Messsignal ermittelt wird und dass mittels des Ultraschallgenerators die Schwingungsfrequenz des Ultraschallwerkzeuges so eingestellt bzw. verändert wird, dass die genannte Phasendifferenz verringert, vorzugsweise bis im wesentlichen oder bis genau auf Null, verringert wird. Es gelingt dadurch, einen Zustand mechanischer Resonanz zu erzeugen, der bei der Herstellung von Bondverbindungen erhebliche Vorteile bietet. Dies einerseits, dass sich in diesem Zustand ein optimales Übertragungsverhalten der Piezoschwingung zum Schweißwerkzeug ergibt und des weiteren nur besonders geringe Verluste auftreten. Erfindungsgemäß besteht die Möglichkeit, den Zustand mechanischer Resonanz kontrolliert anzufahren. In der Vergangenheit war dies unter anderem deshalb nicht möglich, da an den Bondvorrichtungen keine Möglichkeit zur Messung des Zeit-Geschwindigkeits-Verlaufes vorhanden war und insofern auch eine entsprechende Verwendung unbekannt. Statt dessen wurde in der Vergangenheit, allerdings nur mit begrenztem Erfolg, versucht, das Übertragungsverhalten und die Verluste durch die Einstellung von elektrischer Resonanz zu verbessern. Dabei wurde mittels eines Phasenkomparators die Phasendifferenz zwischen Transducerstrom und Transducerspannung ermittelt und mittels eines Phasenreglers unter Veränderung der Schwingungsfrequenz auf Null eingeregelt. Der Zustand elektrischer Resonanz stimmt jedoch in der Regel nicht mit dem gewünschten Zustand der mechanischen Resonanz überein, so dass deren Einstellung nicht kontrolliert möglich war. Es wurde nun gefunden, dass bei der Werkzeugschwingung der Geschwindigkeits-Verlauf dem Messsignal des Piezosensors bis in hohe spektrale Anteile hinein so ähnlich ist, dass die mechanische Resonanz mit hoher Genauigkeit einstellbar ist. Zur Regelung der Phasendifferenz auf den Wert Null kann beispielsweise ein (an sich bekannter) PLL, d. h. phase locked loop bzw. geschlossener Regelkreis verwendet werden.

Eine weitere zweckmäßige Weiterbildung des Verfahrens wird darin gesehen, dass während einzelner Bondvorgänge oder nach dem Bonden mittels des Geschwindigkeits-Verlauf-Messsignals Reibungswert- Zeitverläufe als Ist-Vorläufe bzw. Ist-Vektoren der Reibung ermittelt werden, welche den Verlauf der während der Dauer einzelner Bondvorgänge veränderlichen Reibungskräfte charakterisieren. Die Ermittlung der Reibungswert-Zeitverläufe anhand des Geschwindigkeits-Zeitverlaufes kann auf eine dem Fachmann an sich geläufige Art und Weise erfolgten. Dabei kann eine Folge von Reibungswerten ermittelt werden, von denen jeder Reibungswert einen bestimmten Zeitpunkt eines Bondvorganges zugeordnet ist und dabei seinerseits insbesondere aus einer größeren Anzahl von Messsignalen der Werkzeugspitze abgeleitet worden ist. Das erhaltene "Reibwertsignal" bzw. dessen zeitlicher Verlauf kann als Summensignal der beim Bondvorgang zwischen dem Bondwerkzeug, dem Bonddraht und dem z. B. Substrat (vgl. auch die obigen Ausführungen) aufgefasst werden. Auch die während bspw. eines Bondvorganges erhaltenen Reibungssignale können zur weiteren Verarbeitung bspw. als Vektor behandelt werden. Entsprechend können Vektoren für Geschwindigkeitswerte und für Reibungswerte und für daraus abgeleitete Werte, wie bspw. die Admittanz gebildet werden. Erfindungsgemäß bestehen verschiedene Möglichkeiten, diese Verläufe bedarfsgerecht zur Beeinflussung des nachfolgenden Bondens und/oder zur Beurteilung von Bondergebnissen (Bondqualität) zu verwenden. Es besteht die Möglichkeit, dass der bei einem jeweils aktuellen Prozesszustand des Bondvorganges ermittelte Reibungswert (in dem oben erläuterten Sinne als abgeleitete Größe) zur Steuerung und/oder Regelung des weiteren Bondvorganges und/oder nachfolgender Bondvorgänge, vorzugsweise im Wege einer Beeinflussung von Stellgrößen wie beispielsweise Bondkraft, Ultraschallleistung, Bondzeit und/oder Ultraschallfrequenz verwendet wird. Alternativ oder kombinativ besteht die Möglichkeit, dass aus dem Reibungswert-Zeitverlauf und einem vorgegebenen Soll-Reibungswert-Zeitverlauf oder einem zuvor in einer Lernphase, vorzugsweise gemäß oder analog nachfolgend erläuterten Merkmalen, ermittelten und abgespeicherten Soll-Reibungswert-Zeitverlauf mittels eines Rechners ein die Qualität eines Bondvorganges bzw. einer Bondverbindung kennzeichnender Qualitätswert ermittelt wird. Beispielsweise kann auch der Soll-Verlauf der abgeleiteten Reibung als Vektor dargestellt und in seinen Elementen schrittweise mit zeitlich zugeordneten Elementen des Ist-Vektors verglichen werden. Beispielsweise kann aus den jeweiligen Differenzen ein Abweichungs-Vektor gebildet werden. Bezüglich der Möglichkeit, Sollwertverläufe von Messgrößen und/oder abgeleiteten Größen in einer vorangehenden Lernphase zu erzeugen, wird auch in diesem Zusammenhang Bezug auf die nachfolgende Beschreibung genommen. Auch besteht die Möglichkeit, dass der genannte Qualitätswert zur Steuerung und/oder Regelung von nachfolgenden Bondvorgängen, vorzugsweise im Wege einer Beeinflussung von Stellgrößen wie Bondkraft, Ultraschallleistung, Bondzeit und/oder Ultraschallfrequenz, verwendet wird. Eine weitere bevorzugte Anwendung kann sein, dass der Qualitätswert zur Beeinflussung von Stellgrößen des Bondprozesses, wie insbesondere Bondkraft, Ultraschallleistung, Bondzeit und/oder Ultraschallfrequenz im Wege einer Steuerung oder Regelung und/oder bei Erreichen kritischer Werte zur Ausgabe von Warnsignalen verwendet wird. Es hat sich herausgestellt, dass die während einzelner Bondvorgänge auftretenden Verläufe der Werkzeuggeschwindigkeit in Schwingungsrichtung und daraus abgeleitete Verläufe (insbesondere der abgeleiteten Reibung) je nach Bondbedingungen eine im Vergleich zu herkömmlichen Auswertungsparametern (insbesondere der Drahtverformung) zuverlässigere Aussage über die Qualität eines Bondvorganges ermöglichen können. Das erfindungsgemäße Verfahren ermöglicht daher im Vergleich zum Stand der Technik eine präzisere Überwachung der Bondqualität und bei Bedarf (bspw. bei Änderung der Bondbedingungen) eine verbesserte Beeinflussung von Stellgrößen zum Erhalt einer gleichbleibend guten Bondqualität. Insbesondere besteht die Möglichkeit, einen Soll-Ist-Vergleich der abgeleiteten Reibung in eine Steuerung und/oder Regelung von Bondprozessen zu integrieren, wobei ggf. auch noch zusätzliche Parameter mit berücksichtigt werden könnten.

Betreffend der zuvor erläuterten ersten Weiterbildung schließt die Erfindung auch eine Bondvorrichtung, vorzugsweise einen Drahtbonder, mit ein zur Herstellung und zur Qualitätskontrolle von Ultraschallbondverbindungen, aufweisend eine Transducer-Bondwerkzeug-Einheit und einen Ultraschallgenerator sowie zumindest einen Sensor zur Gewinnung von Messsignalen von zumindest einem während des Bondens variablen Parameter. Zu diesbezüglich bevorzugten Weiterbildungen wird auch auf die Merkmale der Ansprüche 9 bis 14 gemäß der am internationalen Anmeldetag eingereichten Fassung und zu möglichen Vorteilen und Wirkungen Bezug auf die gesamte Beschreibung und die Figuren genommen. Wie in den Ansprüchen 10 bis 14 gemäß der am internationalen Anmeldetag eingereichten Fassung angegeben, besteht die Möglichkeit, dass als Sensor ein Piezosensor vorgesehen ist, der vorzugsweise in/an einer Lagerung des Ultraschalltransducers angeordnet ist und mittels dem insbesondere eine Querdehnung senkrecht zu einer sich ausbreitenden anregenden Ultraschallwelle messtechnisch erfassbar ist. Auch besteht die Möglichkeit, dass die Bondvorrichtung einen Spannungssensor zur Erfassung des dem Ultraschalltransducer zugeordneten Zeit-Generatorspannungs-Verlaufs und einen Phasenregler aufweist, der mit dem Sensor bzw. Piezosensor in Verbindung steht und der die Phasendifferenz zwischen dem Zeit-Generatorspannungs-Verlauf und dem Sensor-Signalverlauf bzw. dem Geschwindigkeitsverlauf-Messsignal mittels eines Phasenkomparators erfasst und diese mittels Veränderung der Werkzeug-Schwingungsfrequenz an dem Ultraschallgenerator zur Erzielung von mechanischer Resonanz der Transducer-Bondwerkzeug-Einheit verringert, insbesondere bis zum vollständigen Verschwinden der Phasendifferenz. Es besteht auch die Möglichkeit, dass die Bondvorrichtung Speichermittel aufweist, in denen zumindest ein vorgegebener Soll-Reibungswert-Zeitverlauf oder zumindest ein zuvor in einer Lernphase ermittelter Soll-Reibungswert-Zeitverlauf ab gespeichert ist, sowie Rechenmittel, die an die Berechnung eines die Qualität eines Bondvorganges bzw. einer Bondverbindung kennzeichnenden Qualitätswertes unter Verwendung des Soll-Reibungs-Verlaufs und des bei einem Bondvorgang ermittelten Reibungswert-Zeitverlaufs als Ist-Verlauf, insbesondere mittels Berechnung eines Abweichungs-Verlaufs aus Differenzen zwischen einander zeitlich entsprechenden Werten beider Verläufe, angepasst sind. Es besteht insofern auch die Möglichkeit, dass die Bondvorrichtung in deren Charakteristik durch den Abweichungs-Verlauf und/oder den Qualitätswert beeinflussbare Steuer- und/oder Regelmittel zur Steuerung und/oder Regelung des aktuellen und/ oder von nachfolgenden Bondvorgängen aufweist, welche insbesondere auf Stellgrößen des Bondprozesses, wie insbesondere Bondkraft, Ultraschallleistung, Bondzeit und Ultraschallfrequenz, Einfluss nehmen. Die Erfindung schließt in diesem Zusammenhang auch selbstständig einen Ultraschallgenerator ein, der die Phase zwischen der Geschwindigkeit der Wedge- Spitze und der Ultraschallspannung regeln kann, so dass das System bei Phase Null in seiner mechanischen Resonanz arbeitet.

Auf der Grundlage der vorangehend beschriebenen Zusammenhänge und Merkmale befasst sich die erste Weiterbildung somit auch mit der Erzeugung prozessintegrierter Qualitätsüberwachungsmodule, insbesondere unter Verwendung von Reibung und mechanischer Admittanz (Quotient aus Geschwindigkeit der Wedge-Spitze und der Spannung des Generators), vorzugsweise bei fest vorgegebenen Referenzdaten (Solldaten). Dabei besteht die Möglichkeit der Verarbeitung von externen Sensorwerten.

Auch besteht die Möglichkeit, dass Transducer-Wedge-System in seiner mechanischen Resonanz oder wahlweise in elektrischer Resonanz zu betreiben. Abgeleitete Größen für die Reibung und die Wedgegeschwindigkeit können aus Messgrößen ermittelt werden.

Messungen mit herkömmlichen Systemen haben insbesondere bei Verwendung dickerer Drähte gezeigt, dass die erfassten physikalischen Größen in Abhängig- keit der Bondoberflächen, der Substratmaterialien, der Steifigkeit des Aufbaus, der Eigenmodi des Gesamtsystems, der verwendeten Wedges und Drähte etc. sehr stark variieren. Die stark applikationsabhängigen Schwankungen der Prozessgrößen lassen die Verwendung von Kennlinien als applikationsübergreifend einsetzbare Referenzdaten bei Dickdrahtbondern nicht zu.

Der Erfindung liegt vor diesem Hintergrund gemäß einer zweiten Weiterbildung die zusätzliche Aufgabe zugrunde, ein Verfahren und eine Vorrichtung bereitzustellen, die zu verschiedensten Anwendungen - trotz unterschiedlicher Eingangsvoraussetzungen - passende Referenzdaten (Solldaten) für die Beurteilung der betrachteten Eingangsdaten erzeugen bzw. dabei im übertragenen Sinne lernen können.

Diese Aufgabe wird beispielsweise zunächst und im wesentlichen in Verbindung mit den ggf. zusätzlichen Merkmalen gelöst,
- dass für zumindest ein bestimmtes Bond Referenzsystem eine Lernphase durchgeführt wird unter Vorgabe von bestimmten, insbesondere dem Bond-Referenzsystem in einer Datenbank zugeordneten, Einstellungen der Bondvorrichtung, wobei die Lernphase ein bestimmtes Kollektiv, d.h. eine bestimmte Anzahl, von Lern-Bondvorgängen umfasst,
- dass während der Zeitdauer von Lern-Bondvorgängen mittels Sensoren jeweils bzw. separat Messsignale von einem oder zeitparallel von mehreren Parametern des Bondprozesses, wie insbesondere Stromstärke und/oder Spannung am Ultraschallgenerator und/oder Drahtverformung und/oder Ultraschallfrequenz bzw. Resonanzfrequenz und/oder Werkzeuggeschwindigkeit in Schwingungsrichtung, aufgenommen und jeweils als insbesondere zeitliche Lern-Verläufe in einem Speicher gehalten werden,
- dass für zumindest einen Parameter für jeweils konstante bzw. gleiche, in den Lern-Verläufen unterschiedene bzw. berücksichtigte Zeitpunkte oder Messschritte aus dem Kollektiv der Lern-Bondvorgänge die Verteilung der Wahrscheinlichkeitsdichte oder der relativen Wahrscheinlichkeit der Messsignal- Werte ermittelt wird, insbesondere unter Verwendung eines Statistikmodells,
- und dass für die jeweiligen Verteilungen jeweils der Maximalwert bestimmt wird, dass aus den Maximalwerten der verschiedenen Verteilungen eine Erwartungs-Kennlinie gebildet wird und dass die Erwartungs-Kennlinie als gelernter Soll-Verlauf des betreffenden Parameters abgespeichert wird.

Die Erfassung von Messsignalen mittels der Sensoren kann kontinuierlich, qua- si kontinuierlich oder ggf. auch mit einer gewünschten geringeren Taktrate durchgeführt werden. Der gewählte Begriff Lernphase soll veranschaulichen, dass während dieser Phase als Referenzverläufe dienende Soll-Verläufe (Soll- Vektoren) mittels des Bondverfahrens bzw. der Bondvorrichtung automatisiert generiert werden. Insofern könnte man anstelle von Lernphase auch von einer Generierungsphase für Referenz-Verläufe bzw. Soll-Verläufe sprechen.

Unter der Annahme, dass für die unterschiedlichen Ausgangsvoraussetzungen stabile Prozesse existieren, deren Prozessparameter die Herstellung von Bondverbindungen mit hinreichend hoher Qualität gewährleisten, kann für jede direkt gemessene und für jede abgeleitete Größe die zu ihr gehörende Statistik gelernt werden. Diese Lernphase dient der Erzeugung von Referenzdaten, die im späteren Automatikbetrieb als Grundlage zur Berechnung der Qualitätsindices dienen. Es wird also keine Kennlinie für die unterschiedlichen Prozesse fest einprogrammiert, sondern die Kennlinien werden unter der oben erwähnten Prämisse vom System selbst erzeugt.

Als Eingangsgrößen können die selben Größen wie bisher beschrieben verwendet werden. Anhand der gelernten Statistik kann man Abweichungen quantitativ bewerten und für eine Qualitätsberechnung nutzen.

Eine zweckmäßige Verfahrensweise wird darin gesehen, dass für unterschiedliche Bond-Referenzsysteme, d. h. für Systeme, die sich bzgl. der Bondbedingungen unterscheiden, jeweils in gesonderten Lernphasen individuelle Soll-Verläufe erzeugt werden. Bei einem ersten Referenzsystem könnte es sich bspw. um ein System mit einem Keramiksubstrat handeln, bei einem zweiten unterschiedlichen Referenzsystem bspw. um einen Stecker, bei einem dritten Referenzsystem bspw. um einen Chip usw.. Die Unterscheidung der dabei unterschiedlichen Bondbedingungen, die zu unterschiedlichen Soll-Verläufen führen können, ist besonders beim sog. Dickdraht-Bonden von Bedeutung, da hier größere Abweichungen als beim Dünndraht-Bonden auftreten können. Insofern wird auch als zweckmäßig angesehen, wenn für ein bspw. bestimmtes Keramiksubstrat in Kombination mit unterschiedlichen Drahtstärken wiederum verschiedene Referenzsysteme gebildet bzw. dazu individuelle Soll-Vektoren angelegt werden. Praktisch kann zur Erzeugung der Soll-Verläufe für ein bestimmtes Referenzsystem so vorgegangen werden, dass während eines ersten Bondvorganges alle für eine Qualitätsbeurteilung im späteren Automatikbetrieb interessierenden Messgrößen parallel aufgenommen und in getrennten Vektoren abgelegt werden, wobei auch Vektoren für aus den Messgrößen abgeleitete Größen gebildet werden können. Dieser Schritt kann dann für einen zweiten und weitere Bondvorgänge wiederholt werden, wobei ein Bondkollektiv bspw. einhundert Bondvorgänge (oder auch eine abweichende Anzahl) umfassen kann. Werden die Messgrößen-Verläufe bspw. mit einer Abtastrate von 50 kHz aufgenommen, resultiert bei einer exemplarischen Dauer eines Bondvorganges von 10 m/sec eine Anzahl von fünfhundert Messwerten für jede Messgröße bzw. Messgrößen-Verlauf. Während der Lernphase sollten solche Einstellungen der Prozessparameter der Bondvorrichtung (bspw. Bondkraft, Ultraschallleistung und Bondzeit) gewählt werden, bei denen der Bondprozess für das spezielle Referenzsystem erwartungsgemäß so gut funktioniert, dass ein überwiegender, insbesondere ein statistisch signifikanter Anteil der erzeugten Bondverbindungen eine gute Bondqualität besitzt und allenfalls ein geringerer, insbesondere ein statistisch weniger signifikanter Anteil der Bondverbindungen eine ungeeignete Qualität aufweist. Solche Einstellungen können entweder von geschultem Personal nach Erfahrungswerten vorgewählt werden oder bspw. einer Datenbank, einem Expertensystem oder dergleichen entnommen werden. Während der Lernphase werden die Werte für alle in die Soll-Kurven bzw. Soll-Verläufe einfließenden Meßgrößen zueinander zeitlich parallel aufgenommen. Dabei besteht in vielfältiger Weise die Möglichkeit, die Messsignale mittels Signalverarbeitungskomponenten (bspw. Recheneinheiten, analogen Übertragungsgliedern usw.) aufzubereiten.

Die gelernten Soll-Verläufe können später bei einem Verfahren zur Herstellung von Bondverbindungen (Produktions- bzw. Automatikbetrieb) zur Qualitätskontrolle der Ultraschallverbindungen verwendet werden. Dazu besteht die Möglichkeit, dass für die Herstellung von Bondverbindungen für ein bestimmtes Bond-Referenzsystern die dazu während einer früheren Lernphase erstellten Soll-Verläufe, beispielsweise aus einer Datenbank, bereitgestellt, beispielsweise in einen Arbeitsspeicher eingelesen werden, dass während der Zeitdauer von Bondvorgängen mittels geeigneter Sensoren jeweils Messsignale von einem oder mehreren Parametern aufgenommen und jeweils als zeitliche Ist-Verläufe in einem Speicher gehalten werden und dass für zumindest einen Parameter aus dem Ist-Verlauf und dem in der Lernphase gelernten Soll-Verlauf Abweichungs-Verläufe als sog. Fehlervektoren ermittelt werden.

Dies kann in schon beschriebener Weise bspw. durch rechnerischen Vergleich voneinander zeitlich zugeordneten Werten aus den Soll- und Ist-Vektoren erfolgen. Es besteht die Möglichkeit, dass der Abweichungs-Verlauf zur Steuerung oder Regelung der aktuellen und/oder nachfolgenden Bondherstellungsvorgänge (Bondvorgänge) verwendet wird. Als zweckmäßige Weiterbildung wird angesehen, dass zu dem Statistikmodell ein Konfidenzintervall von bestimmter Größe um das Verteilungsmaximum vorgegeben wird, dass in den jeweiligen Verteilungen die Werte an dem unteren und/oder oberen Intervallrand ermittelt werden, dass aus den Werten des unteren Intervallrandes eine untere Rand-Kennlinie und/oder aus den Werten des oberen Intervallrandes eine obere Rand-Kennlinie gebildet werden und dass bei der Herstellung von Bondverbindungen ermittelte Ist-Verläufe rechnerisch mit der unteren und/oder der oberen Rand-Kennlinie verglichen werden. Insbesondere besteht die Möglichkeit, dass bei einer Überschreitung der oberen Rand-Kennlinie und/oder bei einer Unterschreitung der unteren Rand-Kennlinie ein Fehlersignal erzeugt wird und/ oder in einer Datenbank abgespeichert wird und/oder dem gebondeten Produkt mittels einer Kennzeichnung zu dessen späterer Aussonderung oder Reparatur zugeordnet wird und/oder wobei von einem Prozesssteuer oder -regelsystem eine Benutzereingabe abgefordert wird. Derartige Alternativen können auch vorgesehen sein, wenn bspw. der für einen jeweiligen Bondvorgang berechnete Qualitätsindex Q (oder einzelne oder mehrere Einzel-Qualitätsindices Qi) bestimmte Grenzwerte über- oder unterschreiten. Es versteht sich, dass die besagten Abweichungs-Verläufe je nach Bedarf für mehrere Parameter ermittelt werden können. Auch besteht die Möglichkeit, dass in der Lernphase aus den Messsignalen von Parametern bzw. aus Erwartungs-Verläufen auch Soll-Verläufe für abgeleitete Parameter ermittelt werden, dass während der anschließenden Herstellung von Bondverbindungen aus den Messsignalen bzw. aus Ist-Verläufen von Messsignalen auch Ist-Verläufe für die besagten abgeleiteten Parameter ermittelt werden und dass aus einander für abgeleitete Parameter zugeordneten Soll-Verläufen und Ist-Verläufen auch den abgeleiteten Parametern zugeordnete Abweichungs-Verläufe ermittelt werden. Die besagten Abweichungs-Verläufe von Messgrößen und/oder abgeleiteten Größen können ihrerseits zur Bestimmung von Einzelqualitätsindices und/oder eines gesamten Qualitätsindex verwendet werden, vorzugsweise gemäß einem oder mehreren oder mit Bezug auf die Figuren beschriebenen Merkmalen. Es besteht auch die Möglichkeit, dass ein oder mehrere Sollvorgänge die gemäß einem oder mehreren der Ansprüche 32 bis 39 gemäß der am internationalen Anmeldetag eingereichten Fassung ermittelt wurden, in einem Verfahren gemäß einem oder mehreren der Ansprüche 15 bis 23 gemäß der am internationalen Anmeldetag eingereichten Fassung verwendet werden. Betreffend diese Vorgänge wird auch bezuggenommen auf die voranliegende Beschreibung. Auch bei dem zuvor beschriebenen Verfahren besteht die Möglichkeit, dass zumindest einzelne oder mehrere Verfahrensschritte mittels Software rechnergestützt automatisch durchgeführt werden.

Die Erfindung schließt auch betreffend ihrer zweiten Weiterbildung weiterhin auch ggf. zusätzlich die Merkmale einer Bondvorrichtung, vorzugsweise einer Ultraschall-Drahtbondvorrichtung, zur Herstellung und/oder zur Qualitätskontrolle von Ultraschall-Bondverbindungen, gemäß Anspruch 42 gemäß der am internationalen Anmeldetag eingereichten Fassung mit ein, die zur Durchführung des erfindungsgemäßen Verfahrens gemäß einem oder mehreren der dazu vorangehend beschriebenen Merkmale geeignet bzw. daran angepasst ausgebildet ist. Demgemäß betrifft die Erfindung eine Bondvorrichtung, insbesondere Ultraschall-Drahtbond-vorrichtung, zur Herstellung und zur Qualitätskontrolle von Ultraschall-Bondverbindungen, aufweisend einen Ultraschallgenerator, einen Transducer und Bondwerkzeug, insbesondere ein Wedge, sowie einen oder mehrere Sensoren zur Erfassung von Messsignalen, insbesondere in Echtzeit, von verschiedenen, während des Bondens variablen Parametern, wie insbesondere Stromstärke und/oder Spannung am Ultraschallgenerator oder Transducer und/oder Drahtverformung und/oder Ultraschallfrequenz bzw. Resonanz- frequenz und/oder Werkzeuggeschwindigkeit in dessen Schwingungsrichtung, wobei die Erfindung vorschlägt, dass die Bondvorrichtung zur Durchführung des Verfahrens gemäß einem oder mehreren der Ansprüche 32 bis 41 gemäß der am internationalen Anmeldetag eingereichten Fassung geeignet bzw. daran angepasst ausgebildet ist. Bezüglich dieser Ansprüche 32 bis 41 wird hier auch Bezug auf die vorangehende Beschreibung genommen. Merkmale zur bevorzugten Weiterbildung einer solchen Bondvorrichtung sind insbesondere auch in den Ansprüche 43 bis 45 gemäß der am internationalen Anmeldetag eingereichten Fassung angegeben. Wie darin angegeben, kann die Bondvorrichtung eine Recheneinheit, insbesondere einen Computer mit Software aufweisen, welche an die automatisierte Ausführung von Verfahrensschritten gemäß einem oder mehreren der dem Anspruch 43 vorangehenden Verfahrensansprüche gemäß der am internationalen Anmeldetag eingereichten Fassung angepasst sind. Wie auch darin angegeben, kann die Bondvorrichtung einzelne oder mehrere Komponenten einer Bondvorrichtung gemäß einem oder mehreren der dem Anspruch 44 vorangehenden Ansprüche gemäß der am internationalen Anmeldetag eingereichten Fassung aufweisen. Wie auch darin angegeben, kann vorgesehen sein, dass die Bondvorrichtung einen Speicher zur Speicherung von in Lernphasen erzeugten Soll-Verläufen aufweist und dass dieser Speicher mit der Bewertungseinheit zur Übertragung der Soll-Verläufe verbunden ist und insbesondere mit der Berechnungseinheit zum Empfang von Qualitätsindices (Q und/oder Qi) aus der Berechnungseinheit verbunden ist. Zu möglichen Wirkungen und Vorteilen wird ferner Bezug auf die gesamte Beschreibung und die Figuren genommen.

Mit Bezug auf die vorangehenden Ausführungen befasst sich die Erfindung mit der Bereitstellung eines selbst-lernenden Systems, wobei die Vorrichtung bzw. das Verfahren zur Erzeugung einer von Produkt und Umgebung abhängigen Statistik als Grundlage der Qualitätsberechnung geeignet ist. In die Qualitätsberechnung können dabei theoretisch beliebig viele Eingangsgrößen einbezogen werden, die als Messgrößen bereitgestellt und/oder als abgeleitete Größen der Messgrößen in Realzeit berechnet werden können, z. B. durch Transformation der Messgrößen, Wavelet-Transformation, Schatzung der Streuung usw.. Es besteht die Möglichkeit der Erzeugung prozessintegrierter Qualitätsüberwachungsmodule unter Verwendung der beschriebenen Eingangsgrößen (Ist-Verläufe bzw. Ist-Vektoren) mit Referenzdaten (Soll-Verläufe bzw. Soll- Vektoren), die für die unterschiedlichen Prozesse in den entsprechenden Lernphasen gelernt bzw. automatisch erzeugt worden sind. Derartige Qualitäts- überwachungsmodule können an einer erfindungsgemäßen Bondvorrichtung (wie auch bei den anderen Aspekten der Erfindung) als Hardwaremodule und/oder als Softwaremodule ausgeführt sein, wobei derartige Module im Rahmen der verschiedenen Aspekte der Erfindung auch Gegenstand von selbstständigen Patentansprüchen sein können. Es besteht die Möglichkeit, eine konstante Anzahl von Eingangsvektoren zu berücksichtigen. Auch besteht die Möglichkeit der Generierung von Merkmalsvektoren durch Korrelation von unterschiedlichen Messgrößen identischer oder unterschiedlicher Zeitintervalle bzw. durch Korrelation von identischen Messgrößen aus unterschiedlichen Zeitintervallen.

Es besteht auch die Möglichkeit, eine variable Anzahl von Eingangsvektoren durch Rückkopplung aus einer Überwachungseinheit zu berücksichtigen. Die Erfindung spiegelt schließlich auch die Möglichkeit der Erzeugung prozessintegrierter Qualitätsüberwachungsmodule unter Verwendung einer von durch eine Überwachungseinheit erweiterten Menge von Eingangsdaten sowie einer adaptiven Qualitätsberechnung. Es besteht die Möglichkeit der Transformation eines Fehlervektors auf eine skalare Qualitätsgröße.

Einer dritten Weiterbildung liegt die zusätzliche Aufgabe zugrunde, das erfindungsgemäße Verfahren vorteilhaft weiterzubilden, so dass insbesondere eine verbesserte Rückmeldung über Betriebszustände ermöglicht wird.

Die Aufgabe wird gemäß der Weiterbildung zunächst und im wesentlichen durch die ggf. zusätzlichen Merkmale gelöst, dass während der Zeitdauer von Bondvorgängen mittels Sensoren Messsignale von mehreren Parametern, wie vorzugsweise Stromstärke und/oder Spannung am Ultraschallgenerator bzw. Transducer und/oder Drahtverformung und/oder Ultraschallfrequenz bzw. Resonanzfrequenz und/oder Werkzeuggeschwindigkeit, aufgenommen und jeweils als zeitliche Ist-Verläufe bereitgestellt, vorzugsweise in einem Speicher abgespeichert, werden, wobei die Möglichkeit besteht, dass aus Messsignalen von einem oder mehreren Parametern des Bondprozesses ein oder mehrere Ist-Verläufe von aus dem/den Parametern abgeleiteten Größen gebildet werden, dass mehrere Ist- Verläufe jeweils einer Vergleichs-Rechenoperation mit einem dem jeweiligen Ist-Verlauf bezüglich des Parameters bzw. der abgeleiteten Größe zugeordneten, in einem Speicher abgespeicherten Soll-Verlauf unterzogen werden, wobei zu den Ist-Verläufen jeweils ein Abweichungs-Verlauf, vorzugsweise durch Vergleich von einander zeitlich zugeordneten Einzelwerten, ermittelt wird, dass mittels geeigneter Rechenmittel aus Abweichungs-Verläufen jeweils ein Einzel-Qualitätsindex (skalare Größe) berechnet wird und dass eine Mehrzahl von Einzel-Qualitätsindices zumindest einer Bondverbindung als Bond-Indexgruppe mit mehreren verschiedenen, in einem Speicher, vorzugsweise in einem Expertensystem, abgelegten Speicher-Indexgruppen, welche sich untereinander durch die Werte der bestimmten Parametern bzw. abgeleiteten Größen zugeordneten Einzel-Qualitätsindices unterscheiden, unter Anwendung von zumindest einem vorgegebenen Ähnlichkeitskriterium verglichen und einer Speicher-Indexgruppe bei Erfüllung zumindest eines Ähnlichkeitskriteriums zugeordnet werden.

Die Ermittlung der genannten Einzel-Qualitätsindices wird dabei im Rahmen der Erfindung auch als Merkmals-Extraktion bezeichnet. In einem einfachen Anwendungsbeispiel kann ein Einzel-Qualitätsindex aus den Werten bzw. Skalaren des zugeordneten Abweichungs-Vektors durch Bildung des mathematischen Betrags ermittelt werden. Bevorzugt ist, dass bei Erfüllung eines Ähnlichkeitskriteriums für eine Speicher-Indexgruppe automatisch ein vorzugsweise elektrisches Klassifikationssignal erzeugt wird; das die Ausgabe von Informationen bewirkt und/oder zur Steuerung oder Regelung einer Bondvorrichtung verwendet wird. Zweckmäßig ist auch, dass verschiedenen Speicher- Indexgruppen in einem Speicher jeweils unterschiedliche Daten über den Betriebszustand einer Bondvorrichtung, vorzugsweise über unterschiedliche Fehlerzustände, zugeordnet sind und dass das erzeugte Klassifikationssignal bzw. Fehlerklassifikationssignal die Ausgabe von Information über diesen Betriebs- bzw. Fehlerzustand bewirkt. Gemäß einem weiteren Aspekt der Erfindung, der auch selbstständig Bedeutung besitzen kann, besteht die Möglichkeit, dass die bei der Merkmalsextraktion gebildeten Einzel-Qualitätsindices (welche bereits keinen Zeitbezug mehr besitzen) und/oder der Qualitätsindex und/oder Klassifikationssignale von während des Bondbetriebs hergestellten Bondverbindungen mittels einer Rechenoperationen ausführenden Überwachungseinrichtung unter Berücksichtigung bekannter Zusammenhänge bzw. Statistiken auf Ausreißer-Bonds analysiert werden. Zur Weiterbildung des Verfahrens kann die Gruppe der einem Ausreißer-Bond zugehörigen Einzel-Qualitätsindices in einem Speicher als eine neue Speicher-Indexgruppe abgespeichert und mit Daten über den Betriebs- bzw. Fehlerzustand verknüpft werden. Es besteht die Möglichkeit, dass von dem Ausreißer-Bond Messsignale, vorzugsweise dessen Ist-Verläufe, mittels Rechenmitteln statistisch zu abgeleiteten Größen umgewandelt und die daraus gebildeten Ist-Verläufe auf signifikante Merkmale, Verläufe usw. untersucht werden. Gemäß einem weiteren Aspekt der Erfindung, der ebenfalls selbstständig von Bedeutung sein kann, besteht auch die Möglichkeit, dass abgeleitete Größen, zu denen signifikante Merkmale festgestellt wurden, bei nachfolgenden Bondprozessen bei der Berechnung des Qualitätsindex verwendet werden. Auf diese Weise wird die Anzahl der Eingangsvektoren für die Merkmals-extraktion und die zukünftige Anzahl der in einer Indexgruppe enthaltenen Werte um 1 vergrößert. Durch ein solches Überwachungssystem wird vorteilhaft eine ständige Erweiterung bzw. Überprüfung der Qualitätsüberwachung sichergestellt und eine bestmögliche Modellbildung erreicht. Gemäß einem weiteren Aspekt der Erfindung, der ebenfalls selbstständig Bedeutung besitzen kann, besteht die Möglichkeit, dass bei vorbestimmten Abweichungen zwischen Bond-indexgruppen und Speicher-Indexgruppen automatisch insbesondere elektrische Signale erzeugt werden, die vorzugsweise in Echtzeit zur Steuerung oder Regelung des aktuellen und/oder nachfolgender Bondvorgänge verwendet werden. Insofern handelt es sich um eine Gegenkopplung in Abhängigkeit von bekannten Speicher-Indexgruppen bzw. Fehlerklassen. Bevorzugt ist auch, dass das Verfahren gemäß einzelnen oder mehreren der zuvor beschriebenen Merkmale automatisiert nach Einstellungs- und/oder Wartungsarbeiten an einer Bondverbindung durchgeführt wird. Als zweckmäßig wird bevorzugt, dass das Verfahren gemäß einem oder mehreren der zuvor beschriebenen Merkmale automatisiert, vorzugsweise rechnergestützt unter Verwendung von Software, durchgeführt wird.

Die Erfindung schließt auch betreffend ihrer dritten Weiterbildung weiterhin auch ggf. zusätzlich die Merkmale einer Bondvorrichtung, vorzugsweise einer Ultraschall-Drahtbondvorrichtung, zur Herstellung und zur Qualitätskontrolle von Ultraschall-Bondverbindungen mit ein, welche gemäß Anspruch 57 gemäß der am internationalen Anmeldetag eingereichten Fassung zur Durchführung des erfindungsgemäßen Verfahrens mit einem oder mehreren der vorangehend beschriebenen Merkmale geeignet bzw. an dessen Ausführung angepasst ist. Demgemäß betrifft die Erfindung eine Bondvorrichtung, insbesondere Ultraschall-Drahtbondvorrichtung, zur Herstellung und zur Qualitätskontrolle von Ultraschall-Bondverbindungen, aufweisend einen Ultraschallgenerator, einen Transducer und Bondwerkzeug, insbesondere ein Wedge, sowie einen oder mehrere Sensoren zur Erfassung von Messsignalen, insbesondere in Echtzeit, von verschiedenen, während des Bondens variablen Parametern, wie insbesondere Stromstärke und/oder Spannung am Ultraschallgenerator oder Transducer und/oder Drahtverformung und/oder Ultraschallfrequenz bzw. Resonanzfrequenz und/oder Werkzeuggeschwindigkeit in dessen Schwingungsrichtung, wobei die Erfindung vorschlägt, dass die Bondvorrichtung Mittel, insbesondere um-fassend einen Rechner mit Software, aufweist, die zur Durchführung eines Verfahrens gemäß einem oder mehreren der Verfahrensansprüche 46 bis 56 gemäß der am internationalen Anmeldetag eingereichten Fassung geeignet bzw. an dessen Ausführung angepasst sind. Bezüglich der genannten Ansprüche 46 bis 56 wird hier auch auf die dazu vorangehende Beschreibung Bezug genommen. Bevorzugte mögliche Weiterbildungen sind auch in den Ansprüchen 58 bis 62 gemäß der am internationalen Anmeldetag eingereichten Fassung angegeben, wobei zu möglichen Wirkungen und Vorteilen in Bezug auf die gesamte Beschreibung und die Figuren genommen wird. Bevorzugte mögliche Weiterbildungen sind auch in den Ansprüchen 58 bis 62 gemäß der am internationalen Anmeldetag eingereichten Fassung angegeben, wobei zu möglichen Wirkungen und Vorteilen in Bezug auf die gesamte Beschreibung und die Figuren genommen wird. Gemäß den in Bezug genommenen Ansprüchen 58 bis 62 gemäß der am internationalen Anmeldetag eingereichten Fassung besteht die Möglichkeit, dass die Bondvorrichtung Komponenten einer Bondvorrichtung gemäß einem oder mehreren der Ansprüche 24 bis 31 gemäß der am internationalen Anmeldetag eingereichten Fassung und insbesondere von weiteren der vorangehenden Ansprüche gemäß der am internationalen Anmeldetag eingereichten Fassung aufweist, wozu auch auf die vorangehende Beschreibung Bezug genommen wird. Wie auch darin angegeben, besteht die Möglichkeit, dass die Bewertungseinheit dazu geeignet bzw. daran angepasst ist, Einzel-Qualitätsindices Qi zu Bond-Indexgruppen zusammenzufassen, dass die Bondvorrichtung einen Speicher aufweist, in welchem Speicher-Indexgruppen und mit diesen separat verknüpfte Daten, insbesondere Daten betreffend bestimmte Betriebszustände der Bondvorrichtung und insbesondere Daten betreffend Fehlerursachen, abgespeichert sind, dass die Vorrichtung ein Klassifikationsmodul umfasst, welches ein Vergleichsmodul aufweist, das an eine vergleichende Zuordnung von Bond-Indexgruppen zu Speicher-Indexgruppen unter Verwendung von vorgegebenen Ähnlichkeitskriterien und an eine Ausgabe von den mit solchen Speicher-Indexgruppen, welche zumindest ein Ähnlichkeitskriterium erfüllen, in einem Speicher verknüpften Daten bzw. Informationen, insbesondere mittels dazu geeigneter Software, geeignet bzw. angepasst ist. Es besteht auch die Möglichkeit, dass die Bondvorrichtung eine Überwachungseinheit umfasst, welche ein Vergleichsmodul aufweist, das insbesondere mittels geeigneter Software unter Verwendung von Ähnlichkeitskriterien an einen Vergleich von Bond-Indexgruppen mit Speicher-Indexgruppen zur Detektion von Ausreißer-Bond-Indexgruppen angepasst ist, die keine oder nur bestimmte Ähnlichkeitskriterien erfüllen. Es besteht auch die Möglichkeit, dass die Überwachungseinheit zur Rückkopplung der Ergebnisse in die Qualitätsberechnung mit der Bewertungseinheit und/oder der Berechnungseinrichtung verbunden ist. Es besteht auch die Möglichkeit, dass die Bewertungseinheit und/oder die Berechnungseinrichtung und/oder das Klassifikationsmodell zur rückwirkenden Beeinflussung, insbesondere in Echtzeit, des aktuellen Bondvorganges oder nachfolgender Bondvorgänge zur Signal- bzw. Datenübertragung mit einer Steuereinrichtung oder einer Regeleinrichtung der Bondvorrichtung verbunden ist, welche auf eine oder mehrere Stellgrößen, insbesondere auf die Bondkraft und/oder die Ultraschallleistung und/oder die Bondzeit, einwirkt.

Gemäß den vorangehenden Erläuterungen ermöglicht die Erfindung die Klassifizierung von bei Bondprozessen möglichen Fehlern, deren automatische Zuordnung zu Fehlerklassen und die automatisierte Benennung von Bondfehlern. Die Erfindung schließt insofern auch die Möglichkeit der Erzeugung von Korrekturgrößen in Realzeit in Abhängigkeit von Eingangstexturen in der Merkmalsextraktion und die Rückkopplung auf die Prozesssteuerung ein. Auch besteht die Möglichkeit der Erzeugung von Korrekturgrößen in der Qualitätsberechnung in Form einer Trendanalyse und der Rückkopplung auf die Prozesssteuerung. Eine weitere Anwendungsmöglichkeit liegt in der Überwachung von Benutzereingriffen und der Überprüfung von Wartungsarbeiten. Die Erfindung ermöglicht auch die Transformation eines Fehlervektors auf eine skalare Qualitätsgröße.

Die Aspekte der vorliegenden Erfindung werden nachfolgend mit Bezug auf die beigefügten Figuren, in denen bevorzugte Ausführungsbeispiele des erfindungsgemäßen Verfahrens und erfindungsgemäßer Vorrichtungen dargestellt sind, näher beschrieben. Dabei zeigt:
- Fig. 1:: in Form eines Blockdiagramms eine zur rechnerischen Ermittlung von Einzel-Qualitätsindices und des Qualitätsindex geeignete Vorrichtung und Verfahrensweise gemäß der Erfindung,
- Fig. 2:: in Diagrammform eine Darstellung eines gelernten Statistikmodells eines Parameters oder einer abgeleiteten Größe,
- Fig. 3:: in Gestalt eines dreidimensionalen Diagramms eine Darstellung der Wahrscheinlichkeitsdichte einer Messgröße für die Abtastzeitpunkte,
- Fig. 4:: ausgehend von dem in Fig. 2 gezeigten Kurvenverlauf ein gewähltes Konfidenzintervall von 95 Prozent,
- Fig. 5:: als Blockdiagramm eine Vorrichtung und ein Verfahren gemäß der Erfindung zur Klassifizierung von Bondfehlern,
- Fig. 6:: ausgehend von Fig. 5 eine Weiterbildung mit Feedback aus der Klassifizierungseinheit zur Prozesssteuerung oder -regelung,
- Fig. 7:: als Blockdiagramm schematisch eine Bondvorrichtung und ein Bondverfahren mit einem Ultraschallgenerator zur Einstellung von elektrischer Resonanz und
- Fig. 8:: als Blockdiagramm schematisch eine Bondvorrichtung und ein Bondverfahren mit einem Ultraschallgenerator zur Einstellung von mechanischer Resonanz.

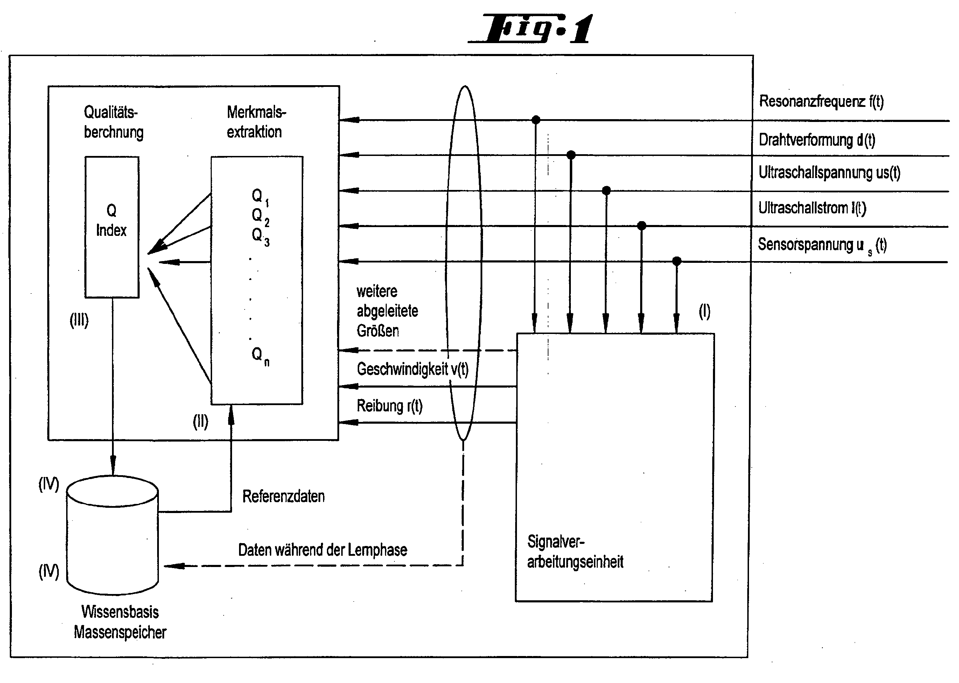

Figur 1 zeigt eine bevorzugte Anordnung von für die Berechnung der Qualitätsindices Q, Qi (d. h. Q₁ bis Qₙ) geeigneten Komponenten. Aus den Sensor-Rohdaten werden mit Hilfe einer speziellen Signalverarbeitungseinheit I die abgeleiteten Größen, unter anderem die Wedgegeschwindigkeit und die Reibung bestimmt. Zusammen mit den bereits genannten Messgrößen Strom, Admittanz, Verformung etc. und der in Realzeit bestimmten Resonanzfrequenz wird für jede dieser Größen in der Bewertungseinheit II im Rahmen der sogenannten Merkmalsextraktion (feature extraction) zunächst ein individueller Qualitätswert Qi berechnet. Diese individuellen Qualitätsindices Qi werden dann an die Berechnungseinheit III zur Qualitätsberechnung (quality calculation) für den Gesamtindex übergeben und dort wird dann der aus den gewichteten Einzelindices Qi der Qualitätsindex Q bzw. Q_{ges} der jeweiligen Bondverbindung berechnet. Dieser wird dann im Speicher IV abgelegt. Stellgrößen sind beispielsweise die Bondkraft, die Ultraschallleistung, die Bondzeit und/oder die Ultraschallfrequenz. Die Einzel-Qualitätsindices Q₁ ...Qₙ können als Vektor behandelt werden, aus welchem der Gesamt-Qualitätsindex Q berechnet werden kann. Jedes Element Q₁ (d. h. Q₁...Qₙ) stellt eine skalare Größe dar, die aus jeweils einem Abweichungs-Verlauf bzw. Abweichungs-Vektor einer Messgröße oder eine abgeleiteten Größe berechnet wurde, beispielsweise kann es sich bei der skalaren Größe um den, insbesondere bzgl. seiner einzelnen Elemente gewichteten, Vektorbetrag handeln.

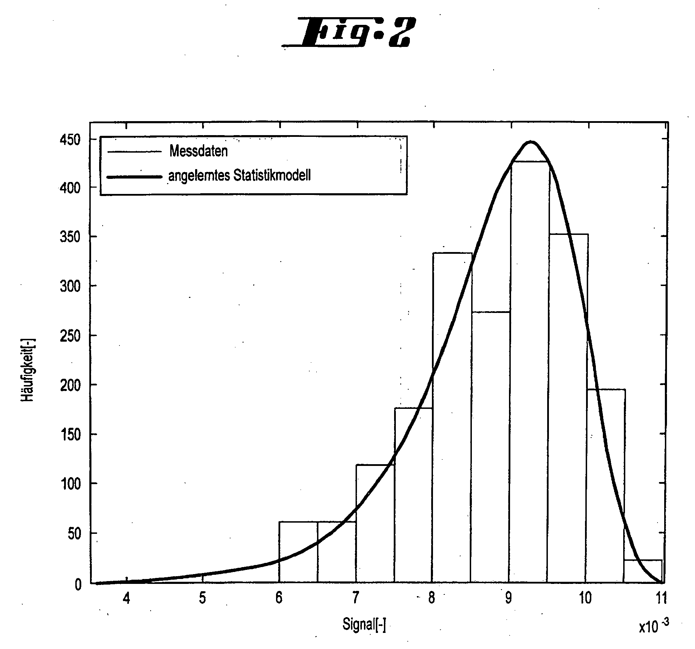

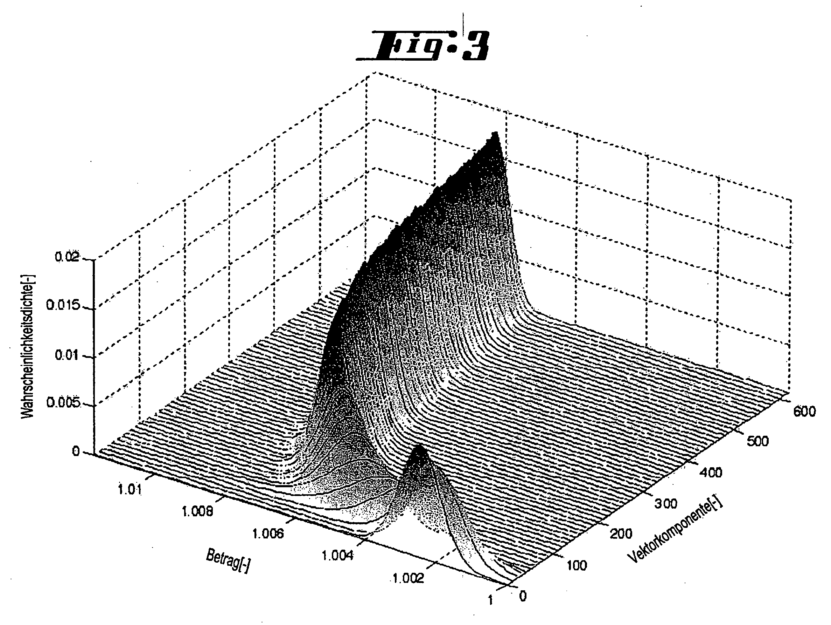

Aus den Messdaten, die gemäß einem Aspekt der Erfindung während der Lernphase aufgenommen werden, kann ein Modell für die Verbindungsbildung erzeugt werden, das für die Beurteilung der Verbindungsgüte geeignet ist Die Figuren 2 bis 4 veranschaulichen eine bevorzugte die prinzipielle Vorgehensweise bei der Erzeugung einer für eine jeweilige Messgröße geltenden Statistik. In Figur 2 wird exemplarisch die Wahrscheinlichkeitsverteilung einer Messgröße zu einem bestimmten Abtastzeitpunkt dargestellt. Zeichnet man alle abgetasteten Größen auf und betrachtet die relative Häufigkeit ihrer Amplituden, so erhält man auf diese Weise eine zweidimensionale Wahrscheinlichkeitsdichtefunktion über den Betrag der einzelnen Vektorkomponenten. Eine derartige Wahrscheinlichkeitsverteilung wird ebenfalls nur beispielhaft in Figur 3 dargestellt. Aus dieser Darstellung werden die Sollwertverläufe für die jeweiligen Messgrößen dadurch erzeugt, dass die Komponenten des Soll-Vektors bzw. des Soll-Verlaufes die jeweiligen Mittelwerte annehmen. Trägt man die jeweiligen Mittelwerte in einem Koordinatensystem über der Zeitachse zu den jeweiligen Abtastzeitpunkten ab und verbindet die Punkte durch eine Linie (Bezier, Spline o. ä.), dann erhält man die Kennlinie der betroffenen Messgröße für die gelernte Applikation, d. h. einen erfindungsgemäß erzeugten (d. h. "gelernten") Soll-Vektor bzw. Soll-Verlauf. Man kann diese Zahlenfolgen auch als einen Zeitvektor auffassen, dessen Komponenten genau einem Abtastzeitpunkt zugeordnet sind.

Es können allerdings auch Eingangsvektoren Verwendung finden, deren Komponenten bestimmten Werten anderer Messgrößen zugeordnet sind, so dass nicht jeder Vektor Komponenten enthält, die äquidistanten Abtastzeitpunkten zugeordnet werden können. Die Längen der Merkmalsvektoren können ebenfalls unterschiedlich sein, da ihre Wirkung auf das System für unterschiedlich große Bereiche der Bezugsgrößen von Bedeutung sein kann.

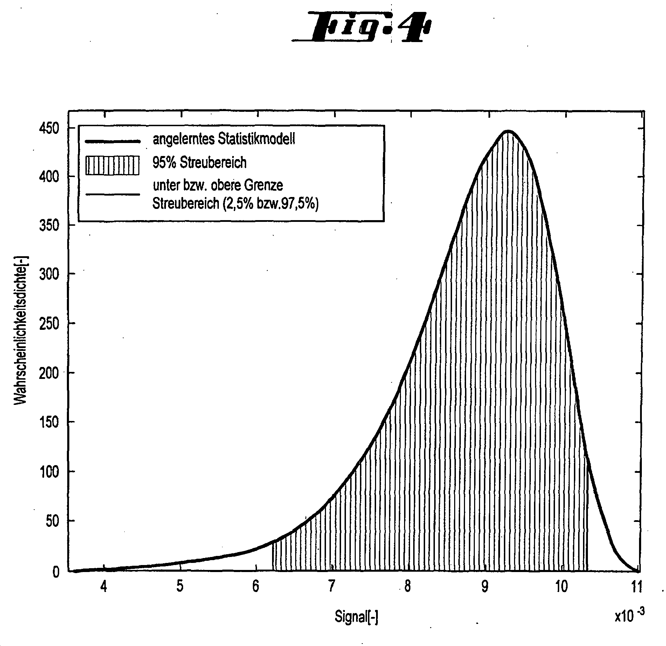

Die Statistikmodelle können in Abhängigkeit von der Eingangsgröße gewählt werden. Die Mindestmenge an Referenzbonds für eine repräsentative Statistik hängt vom gewählten Modell ab. Grundsätzlich sollte eine möglichst große und repräsentative Stichprobe angestrebt werden. Die Mindestgröße wird durch das System als Konstante fest vorgegeben. Die Größe des Streubereiches bzw. des Konfidenzintervalls (Figur 4) ist ein einstellbarer Parameter, zum Beispiel ein 99%-Streubereich; die Lage des Streubereiches bzw. des Konfidenzintervalls (Figur 4) um den jeweiligen Stichprobenmittelpunkt ergibt sich aus der gelernten Wahrscheinlichkeitsdichtefunktion und hängt somit vom gewählten Modell und von den Referenzdaten ab.

Die Qualitätsberechnung ist vorzugsweise in zwei Stufen unterteilt, nämlich in die Merkmalsextraktion bzw. Ermittlung der Einzel-Qualitätsindices Qi (Figur 1, Block II) und in die Qualitätsberechnung des Qualitätsindex Q (Figur 1, Block III). Zunächst wird zu jeder Größe (Parameter des Bondprozesses oder abgeleitete Größe) aus der zweidimensionalen Wahrscheinlichkeitsdichtefunktion der zu dem jeweiligen Abtastzeitpunkt gehörende Erwartungswert (statistischer Maximalwert) berechnet. Für alle Eingabegrößen (Komponenten der Eingangsvektoren) wird der Abstand zwischen Messwert und Stichprobenreferenzwert (Mittelwert, Median, Schwerpunkt etc.) bestimmt. Diese Merkmalsvektoren werden vorzugsweise komponentenweise auf die Ausdehnungen der Konfidenzintervalle normiert. Für die Auswertung können die aus der Statistik bekannten Methoden eingesetzt werden. Bei der Berechnung der Qualitätsindices werden für die jeweiligen Messgrößen unterschiedliche Statistiken, die sich an das zugrunde liegende Modell bestmöglich anpassen, verwendet. Die Gewichtung der einzelnen Werte und der Zeitraum, in dem diese Werte betrachtet werden, sind einstellbar. So kann zum Beispiel der Verformungsverlauf des Drahtes zu Beginn des Bondprozesses ohne Bedeutung sein bzw. kann unter Umständen in dieser Phase keine durch den Ultraschall hervorgerufene Verformung stattfinden. Sie kann also für die ersten Millisekunden des Prozesses unbeobachtet bleiben. Andere physikalische Effekte können insbesondere am Anfang des Schweißprozesses von großer Bedeutung sein, so beispielsweise der zeitliche Verlauf der Reibung zwischen den Verbindungspartnern. Schließlich werden die aus den Qi's bestehenden Vektoren noch weiteren Transformationen unterzogen, um abgeleitete, von Störeinflüssen bereinigte Größen zu erhalten. Auf diese Weise werden weitere Merkmalsvektoren hergestellt.

In einem nächsten Schritt werden die n Merkmalsvektoren am Eingang der Merkmalsextraktion auf n Skalare am Ausgang abgebildet. Diese können abermals als Vektor mit n Komponenten betrachtet werden und dienen der Qualitätsberechnung als Eingangsgröße. In der Qualitätsberechnung wird dieser Vektor nach einer der Bedeutung der Komponenten festgelegten Prozedur auf ein Skalar abgebildet. Dieses Skalar ist der gesuchte Qualitätswert Q. Ein Schwellwert, der je nach Ausgestaltung einen Eingriff durch einen Bediener notwendig machen kann, ist ein einstellbarer Parameter.

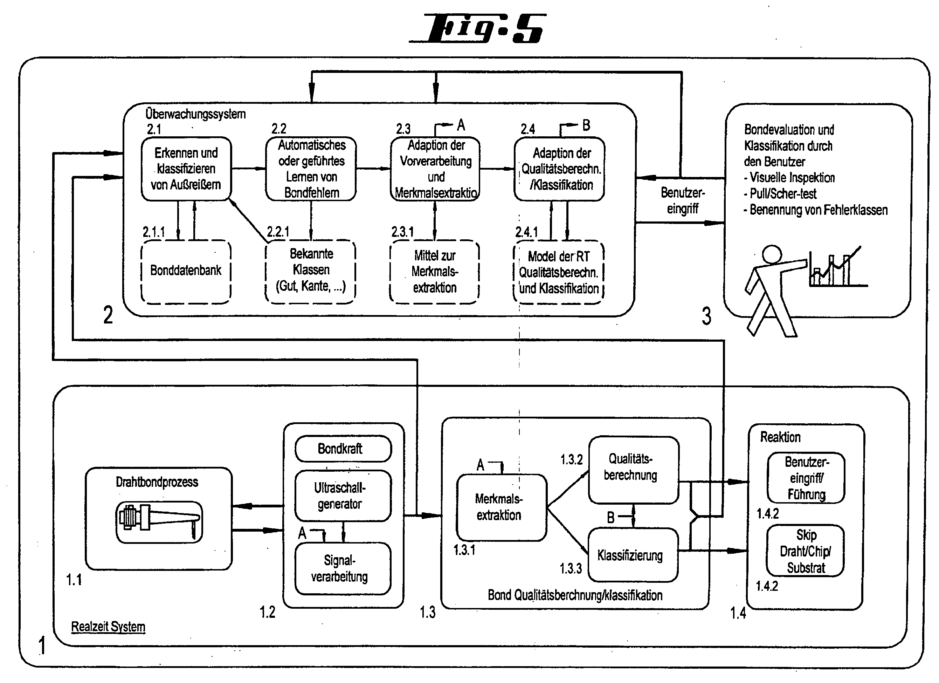

In Fortführung bzw. Weiterbildung der vorerwähnten Möglichkeiten können in einem weiteren Schritt Merkmalsvektoren (Q₁...Qₙ) bzw. Fehlervektoren hinsichtlich zu ihnen gehörender Fehler kategorisiert werden. Figur 5 zeigt den bevorzugten prinzipiellen Aufbau eines dazu geeigneten Systems. Die Berechnung der Qualitätswerte findet prinzipiell wie in Ausführungsform zwei beschrieben statt. Es wird ein weiteres Modul zur Verfügung gestellt, welches das Ergebnis einer Ergebnisklasse zuordnet und insoweit Fehlerursachen angeben kann (vgl. Figur 5, Block 1.3.3).

Die Rohdaten aus der Signalvorverarbeitung und dem Ultraschallgenerator werden nicht nur zur Merkmalsextraktion (feature extraction, Figur 5, 1.3.1) verwendet, sondern ebenfalls an eine nicht in Realzeit arbeitende Überwachungseinheit weitergeleitet. Ebenfalls erhält die Überwachungseinheit das Ergebnis der Qualitätsberechnung und des Fehlerklassifikators (Figur 5, 1.3.2 und 1.3.3). Die Merkmalsextraktion, die Qualitätsberechnung und die Fehlerklassifikation verfügen jeweils über einen weiteren Eingang, über den die Ergebnisse der Überwachungseinheit in die Berechnung der Qualitätswerte rückgekoppelt werden.

Das Überwachungssystem verarbeitet die oben genannten Werte unter Berücksichtigung der aktuell bekannten Statistiken. Es wird beispielsweise bei Substratwechsel oder nach einer vorher festgelegten Anzahl von durchgeführten Bondverbindungen aktiviert und untersucht die eingegangenen Daten zunächst auf Ausreißer (Figur 5, 2.1, (Ausreißer-Erkennung, Klassifikation)). Werden Ausreißer festgestellt, so werden diese an Block 2.2 (automatical or user guided learning of bond failure) übergeben und der Anwender hierüber in Kenntnis gesetzt. Es besteht die Möglichkeit, nach Untersuchung der aufgefallenen Bondverbindung dem System einen entsprechenden Fehlernamen mitzuteilen bzw. anhand des Untersuchungsergebnisses ein neues Merkmal als ein Qualitätsfeature freizugeben. Findet keine Benutzereingabe statt, so klassifiziert das Überwachungssystem den Ausreißer automatisch und weist einen automatisch generierten ID-Code ohne mnemonischen Bezug zu. Dieser neue Datenvektor wird an Block 2.3 der Überwachungseinheit übergeben und hier zu einem neuen Merkmalsvektor aufbereitet. Von hier aus wird auf das Realzeitsystem zurückgekoppelt (Figur 5, Block 1.3.1, Pfad A), die Anzahl der Eingangsvektoren für die Merkmalsextraktion wird um eins vergrößert (Block 1.3.1, Figur 5). In der hier beschriebenen Form entspricht dieser neue Eingangsvektor einer Kombination der von außen kommenden Rohdaten bzw. einer Transformation der Daten durch die Signalverarbeitungseinheit, siehe auch Figur 5, Block 1.2.

Die Dimension des Eingangsvektors für die Qualitätsberechnung/Fehlerklassifizierung wird damit ebenfalls um eins vergrößert. Der neue Merkmalsvektor wird des weiteren von Block 2.3 an Block 2.4 (Adaption der Qualitätsberechnung und Klassifikation) übergeben. In diesem Bereich wird anhand der neuen Daten das Modell auf Konsistenz überprüft, ggf. adaptiert und an die Qualitätsberechnung und den Fehlerklassifikator zurückgegeben (Figur 5, Block 1.3.2 und 1.3.3, Pfad B). Auf diese Weise wird durch das Überwachungssystem eine ständige Erweiterung bzw. Überprüfung der Qualitätsüberwachung sichergestellt und eine bestmögliche Modellbildung erreicht.

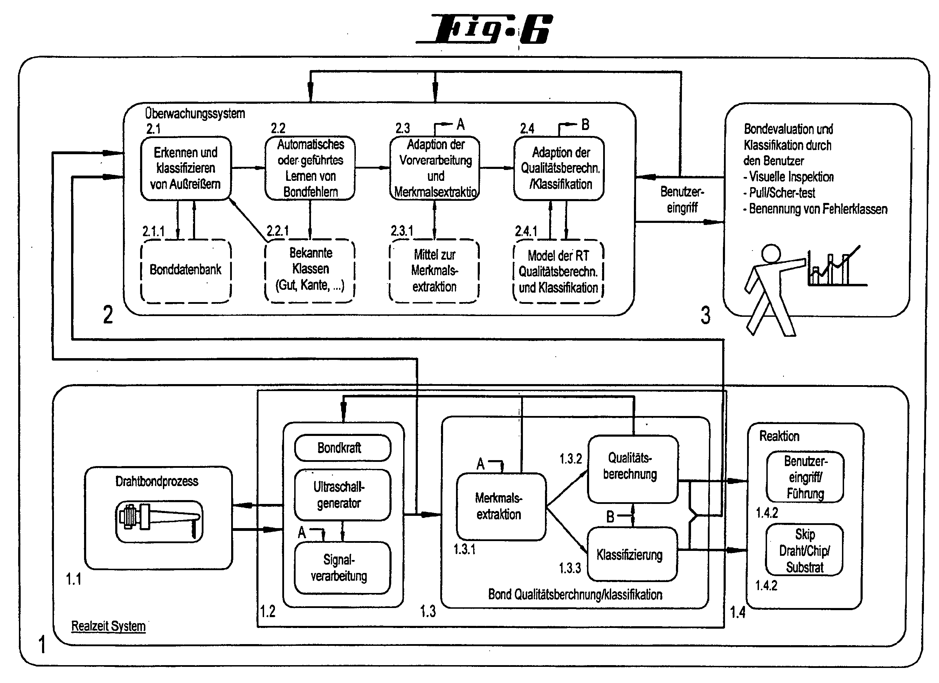

Gemäß einem weiteren Aspekt der Erfindung kann in Kenntnis der berechneten Qualität und des zugrunde liegenden Modells bereits bei der Berechnung der zu den einzelnen Messgrößen gehörenden Vektorkomponenten, die in aller Regel eine Funktion der Zeit sind, in Realzeit eine Abweichung vom Modell bemerkt und durch geeignete Parameteranpassung zur Prozesslaufzeit auf den Prozess eingewirkt werden (siehe auch Figur 6, Gegenkopplung von 1.3.1 und 1.3.2 auf 1.2). Ein gegengekoppeltes System wird zwar auch von EP 1 023 139 beschrieben, allerdings liegt dort lediglich ein fest vorgegebenes Modell in Form von Kennlinien zugrunde. Die Bestimmung von Fehlerklassen und die Gegenkopplung in Abhängigkeit dieser Fehlerklassen und die Gegenkopplung in Abhängigkeit dieser Fehlerklassen ist dort nicht offenbart. Insoweit stellt die vorliegende Erfindung eine völlig neue Lösung bereit, die auch eine fehlerbezogene Rückkopplung auf die den Schweißprozess beeinflussenden Größen erlaubt.

Gemäß einem weiteren Aspekt der Erfindung, welcher auch eigenständig von Bedeutung sein kann, können die zuvor beschriebenen Verfahrensschritte und Merkmale eine Bondvorrichtung auch zur Überprüfung von Benutzereingriffen verwendet werden. Aufgrund einer genauen Kenntnis eines Transducer-Wedge-Systems kann auch beispielsweise überprüft werden, ob beispielsweise der Transducer nach Wartungsarbeiten korrekt montiert ist, ob das Wedge ordnungsgemäß eingebaut wurde und mit der richtigen Vorspannung der Wedgeschraube fixiert wurde. Auch die Beschaffenheit der Klemmung und der Bondaufnahme kann anhand der gelernten Texturen bzw. Verläufe auf korrekte Funktion hin überprüft werden.

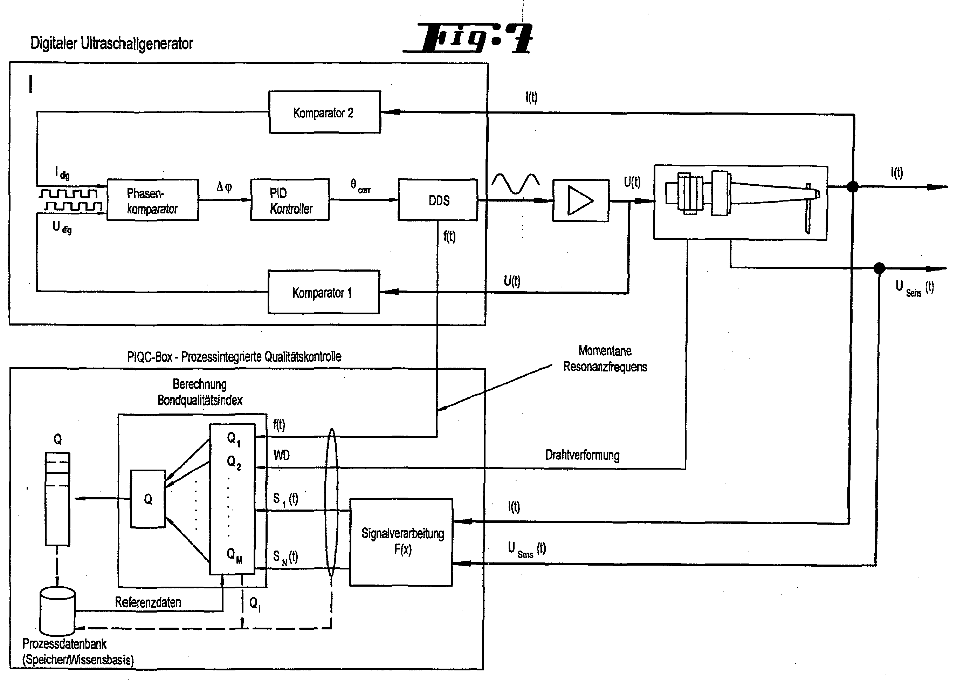

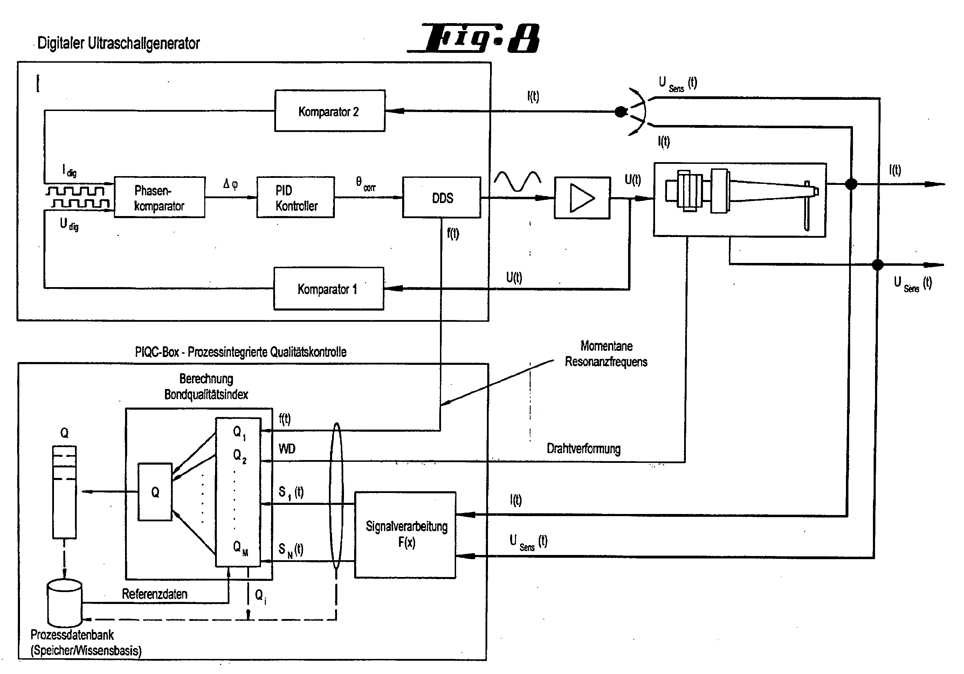

In Block I der Figuren 7 und 8 sind wesentliche Komponenten eines Ultraschallgenerators gemäß einer ersten Ausführungsform dargestellt. Die Komparatoren 1 und 2 formen die Sinussignale für Strom und Spannung jeweils in Rechtecksignale um, deren Nulldurchgang jeweils mit den Nulldurchgängen der Sinusschwingungen zusammenfallen. Mit dem Phasenkomparator wird dann die Phasendifferenz zwischen Strom und Spannung des Ultraschallsignals bestimmt. Der so bestimmte Phasen-Istwert wird dem nachfolgenden Phasenregler (PID-Controller) als Eingangsgröße zugeführt. Der Phasen-Sollwert für Resonanz ist Null. Die Ausgangsgröße des Reglers ist die Eingangsgröße des DDS (Direct Digital Synthesizer), die Größe θ_{corr} ist das Phaseninkrement, anhand dessen die Frequenz des Ausgangssignals des DDS eingestellt wird. Dieses Signal wird dann mittels eines Leistungsverstärkers verstärkt und dem Ultraschall-Transducer zugeführt. Der Regler verändert am Ausgang seine Größe θ_{corr} so, dass die daraus resultierende Frequenz des DDS an der Last (Transducer-Wedge-System) die Phasendifferenz Null zwischen der Ultraschallspannung und Ultraschallstrom ergibt. Eine solche Anordnung ist geeignet zur Einstellung von elektrischer Resonanz.

In Figur 8, welche eine gegenüber Figur 7 modifizierte und bevorzugte Ausführungsform zeigt, kann man wählen, ob der Strom oder ein alternatives Sensorsignal über den Komparator zum Phasenvergleich geführt wird. Das alternative Sensorsignal ist - von einem Phasenoffset abgesehen - ein Maß für die Wedgegeschwindigkeit und kann insoweit zur Einstellung der mechanischen Resonanz verwendet werden.

## Patentansprüche

1. Verfahren zur Qualitätskontrolle beim Ultraschall-Bonden, bei welchem eine Transducer-Bondwerkzeug-Einheit und ein Ultraschall-Generator verwendet werden und bei dem während des Bondens Messsignale von mehreren, während des Bondens variablen Parametern zur Beurteilung der Bondqualität und /oder zur Beeinflussung des Bondens erfasst werden,
wobei,
- während der Zeitdauer von Bondvorgängen mittels Sensoren Messsignale von mehreren Parameternaufgenommen und jeweils als zeitlicher Ist-Verlauf bereitgestellt werden,
- aus Messsignalen von mehreren Parametern des Bondprozesses ein oder mehrere Ist-Verläufe von aus den Parametern abgeleiteten Größen gebildet werden,
- ein oder mehrere Ist-Verläufe jeweils einer Rechenoperation, insbesondere einer Vergleichsoperation, mit einem dem jeweiligen Ist-Verlauf bezüglich seines Parameters bzw. seiner abgeleiteten Größe zugeordneten, in einem Speicher (IV) abgelegten Soll-Verlauf unterzogen werden, wobei zu den Ist-Verläufen jeweils ein Abweichungs-Verlauf, insbesondere durch Vergleich von einander zeitlich zugeordneten Einzelwerten von Ist- und Soll-Verläufen, ermittelt wird, wobei für den Soll-Verlauf auf Basis eines Statistikmodells ein Konfidenzintervall von bestimmter Größe um das Verteilungsmaximum zu den jeweiligen Abtastzeitpunkten vorgegeben wird, wobei in den jeweiligen Verteilungen die Werte an dem unteren und/oder oberen Intervallrand ermittelt werden, wobei aus den Werten des unteren Intervallrandes ein unterer Rand-Kennlinienverlauf und/oder aus den Werten des oberen Intervallrandes ein oberer Rand-Kennlinienverlauf gebildet werden und wobei die bei der Herstellung von Bondverbindungen ermittelten Ist-Verläufe rechnerisch mit der unteren und/oder oberen Rand-Kennlinie verglichen werden,
- mittels geeigneter Rechenmittel aus einem oder mehreren Abweichungs-Verläufen jeweils ein Einzel-Qualitätsindex Qi und/oder ein die Qualität eines einzelnen Bondvorganges bzw. einer einzelnen Bondverbindung zusammengefasst charakterisierender Qualitätsindex Q berechnet und zur Steuerung oder Regelung von folgenden Bondprozessen verwendet wird, **dadurch gekennzeichnet, dass**
- die mehreren Parameter wenigstens eine Geschwindigkeit der Werkzeugspitze und eine Generatorspannung umfassen und dass
- die mehreren Ist-Verläufe von aus den Parametern abgeleiteten Größen wenigstens die mechanische Admittanz als Quotient der beiden Messgrößen Werkzeuggeschwindigkeit und Generatorspannung umfassen und dass
- bei der Berechnung ein oder mehrere Abweichungs-Verläufe zeitlich bzw. in ihrem Verlauf bzw. bezüglich der verschiedenen Elemente des Abweichungs-Vektors veränderlich gewichtet werden.

2. Verfahren nach Anspruch 1, **dadurch gekennzeichnet, dass** die Soll-Verläufe entweder fest vorgegeben sind oder zuvor in einer Lernphase ermittelt wurden.

3. Verfahren nach Anspruch 1 oder 2, **dadurch gekennzeichnet, dass** ein oder mehrere, insbesondere voneinander unabhängig gewichtete und/oder zeitlich gewichtete Abweichungsverläufe und/oder ein oder mehrere Qualitätsindices Qi und/oder der Qualitätsindex Q zur Steuerung oder Regelung eines gerade laufenden und/oder nachfolgender Bondvorgänge verwendet werden.

4. Verfahren nach Anspruch 2, **dadurch gekennzeichnet,**
- **dass** für zumindest ein bestimmtes Bond-Referenzsystem eine Lernphase durchgeführt wird unter Vorgabe von bestimmten, insbesondere dem Bönd-Referenzsystem in einer Datenbank zugeordneten, Einstellungen der Bondvorrichtung, wobei die Lernphase ein bestimmtes Kollektiv von LernBondvorgängen umfasst,
- **dass** während der Zeitdauer von Lern-Bondvorgängen mittels Sensoren jeweils Messsignale von einem oder zeitparallel von mehreren Parametern des Bondprozesses, wie insbesondere Stromstärke und /oder Spannung am Ultraschallgenerator und/oder Drahtverformung und/oder Ultraschallfrequenz bzw. Resonanzfrequenz und/oder Werkzeuggeschwindigkeit in Schwingungsrichtung, aufgenommen und jeweils als insbesondere zeitliche Lern-Verläufe in einem Speicher gehalten werden, und
- **dass** für zumindest einen Parameter für jeweils konstante bzw. gleiche, in den Lern-Verläufen unterschiedene bzw. berücksichtigte Zeitpunkte oder Messschritte aus dem Kollektiv der Lern-Bondvorgänge die Wahrscheinlichkeitsdichtefunktion oder der relativen Wahrscheinlichkeit der Messsignal-Werte ermittelt wird.

5. Verfahren nach Anspruch 4, **dadurch gekennzeichnet,**
- **dass** für die Herstellung von Bondverbindungen bzw. im Automatikbetrieb für ein Bond-Referenzsystem die dazu während einer Lernphase erstellten Soll-Verläufe bereitgestellt werden,
- **dass** während der Zeitdauer von Bondvorgängen mittels Sensoren jeweils Messsignale von einem oder mehreren Parametern aufgenommen und jeweils als Ist-Verläufe in einem Speicher gehalten werden und dass für zumindest einen Parameter aus dessen Ist-Verlauf und dem dafür in der Lernphase ermittelten Soll-Verlauf ein Abweichungs-Verlauf ermittelt wird.

6. Verfahren nach einem oder mehreren der vorangehenden Ansprüche 4 und 5,
**dadurch gekennzeichnet, dass** der Abweichungs-Verlauf zur Steuerung oder Regelung des aktuellen und/oder nachfolgender Bondvorgänge verwendet wird.

7. Verfahren nach einem der Ansprüche 1 bis 6, **dadurch gekennzeichnet, dass** während der Zeitdauer von Bondvorgängen mittels Sensoren Messsignale vor einem oder mehreren weiteren Parametern wenigstens umfassend die Stromstärke und/oder Spannung am Ultraschall-Generator oder Transducer und/oder Drahtverformung und/oder Ultraschallfrequenz bzw. Resonanzfrequenz aufgenommen und jeweils als zeitlicher Ist-Verlauf bereitgestellt werden.

8. Bondvorrichtung, insbesondere Ultraschall-Drahtbondvorrichtung, zur Herstellung und zur Qualitätskontrolle von Ultraschall-Bondverbindungen, aufweisend einen Ultraschallgenerator, einen Transducer und Bondwerkzeug, insbesondere ein Wedge, sowie mehrere Sensoren zur Erfassung von Messsignalen, insbesondere in Echtzeit, von verschiedenen, während des Bondens variablen Parametern, die Bondvorrichtung eine Signalverarbeitungseinheit (I) aufweist, und Mittel, welche Bestandteil der Signalverarbeitungseinheit (I) sind, aufweist zur Erzeugung und Bereitstellung von Ist-Verläufen einzelner Parameter und/oder daraus abgeleiteter Größen, wobei die Ist-Verläufe Messwerten aus einem oder mehreren Bondvorgängen zugeordnet sind,
- die Bondvorrichtung einen Speicher (IV) aufweist, in welchem Soll-Verläufe zu Parametern und /oder abgeleiteten Größen abgespeichert sind,
- die Bondvorrichtung eine Bewertungseinheit (II) aufweist, welche mit dem Speicher (IV) sowie mit den Sensoren und/oder der Signalverarbeitungseinheit (I) in Verbindung steht und welche für einen oder mehrere ausgewählte Parameter und/oder abgeleitete Größen gesondert aus Ist-Verläufen und aus Soll-Verläufen gleicher Parameter bzw. abgeleiteter Größen Abweichungs-Verläufe und daraus Einzel-Qualitätsindices Qi ermittelt,
- die Bondvorrichtung eine Berechnungseinheit (III) aufweist, welche mit der Bewertungseinheit (II) verbunden ist und welche aus einzelnen oder mehreren Einzel-Qualitätsindices Qi einen Qualitätsindex Q berechnet, **dadurch gekennzeichnet, dass** die Bondvorrichtung zur Durchführung des Verfahrens gemäß einem oder mehreren der Ansprüche 1 bis 3 geeignet ausgebildet ist und:
- die während des Bondens variablen Parametern wenigstens die Geschwindigkeit der Werkzeugspitze in dessen Schwingungsrichtung und die Generatorspannung umfassen,
- dass die Signalverarbeitungseinheit (I) Parameter-Sensordaten aufbereitet und abgeleitete Größen wenigstens umfassend die mechanische Admittanz als Quotient der beiden Messgrößen Werkzeuggeschwindigkeit und Generatorspannung, aus den Parametern ermittelt.

9. Bondvorrichtung nach Anspruch 8, **dadurch gekennzeichnet, dass** die Bewertungseinheit (II) Mittel aufweist zur verlaufsmäßigen Gewichtung der Abweichungs-Verläufe bei der Berechnung der Einzel-Qualitätsindices Qi.

10. Bondvorrichtung nach einem oder mehreren der vorangehenden Ansprüche 8 und 9, **dadurch gekennzeichnet, dass** die Bondvorrichtung eine Steuerungseinrichtung oder eine Regelungseinrichtung zur Steuerung bzw. Regelung des Bondprozesses aufweist, dass die Bewertungseinheit (II) und/ oder die Berechnungseinheit (III) mit der Steuerungs- bzw. der Regelungseinrichtung der Bondvorrichtung zur Übertragung von Daten, insbesondere von unabhängig voneinander und/oder zeitlich gewichteten Abweichungs-Verläufen und/oder von Einzel-Qualitätsindices Qi und/ oder dem Qualitätsindex Q, verbunden ist und dass die Steuerungs- bzw. die Regelungseinheit die übertragenen Daten zur Steuerung bzw. Regelung des Bondprozesses, insbesondere zur Beeinflussung der Bondkraft und/oder der Ultraschallleistung und/oder der Bondzeit als Stellgrößen, verwendet.

11. Bondvorrichtung nach einem der Ansprüche 8 bis 10 **dadurch gekennzeichnet,**
- **dass** die Bondvorrichtung Mittel, insbesondere umfassend einen Rechner mit Software, aufweist, die zur Durchführung eines Verfahrens gemäß einem oder mehreren der vorangehenden Verfahrensansprüche 1 bis 7 geeignet bzw. an dessen Ausführung angepasst sind,
- **dass** die Bewertungseinheit (II) dazu geeignet bzw. daran angepasst ist, Einzel-Qualitätsindices Qi zu Bond-Indexgruppen zusammenzufassen,
- **dass** die Bond Vorrichtung einen Speicher aufweist, in welchem Speicher-Indexgruppen und mit diesen separat verknüpfte Daten, insbesondere Daten betreffend bestimmte Betriebszustände der Bondvorrichtung und insbesondere Daten betreffend Fehlerursachen, abgespeichert sind,
- **dass** die Vorrichtung ein Klassifikationsmodul umfasst, welches ein Vergleichsmodul aufweist, das an eine vergleichende Zuordnung von Bond-Indexgruppen zu Speicher-Indexgruppen unter Verwendung von vorgegebene Ähnlichkeitskriterien und an eine Ausgabe von den mit solchen Speicher-Indexgruppen, welche zumindest ein Ähnlichkeitskriterium erfüllen, in einem Speicher verknüpften Daten bzw. Informationen, insbesondere mittels dazu geeigneter Software, geeignet bzw. angepasst ist.

12. Bondvorrichtung gemäß Anspruch 11, **dadurch gekennzeichnet, dass** die Bondvorrichtung eine Überwachungseinheit umfasst, welche ein Vergleichsmodul aufweist, das insbesondere mittels geeigneter Software unter Verwendung von Ähnlichkeitskriterien an einen Vergleich von Bond-Indexgruppen mit Speicher-Indexgruppen zur Detektion von Ausreißer-Bond-Indexgruppen angepasst ist, die keine oder nur bestimmte Ähnlichkeitskriterien erfüllen, und dass die Überwachungseinheit zur Rückkopplung der Ergebnisse in die Qualitätsberechnung mit der Bewertungseinheit II und/oder der Berechnungseinrichtung (III) verbunden ist.

13. Bondvorrichtung gemäß einem oder mehreren der vorangehenden Ansprüchen 11 und 12, **dadurch gekennzeichnet, dass** die Bewertungseinheit (II) und/oder die Berechnungseinrichtung (III) und/oder das Klassifikationsmodell zur rückwirkenden Beeinflussung, insbesondere in Echtzeit, des aktuellen Bondvorganges oder nachfolgender Bondvorgänge zur Signal- bzw. Datenübertragung mit einer Steuereinrichtung oder einer Regeleinrichtung der Bondvorrichtung verbunden ist, welche auf eine oder mehrere Stellgrößen, insbesondere auf die Bondkraft und/oder die Ultraschallleistung und/oder die Bondzeit, einwirkt.

## Claims

1. Method for quality control during ultrasonic bonding, in which a transducer-bonding tool unit and an ultrasonic generator are used and in which, during bonding, measurement signals of a plurality of parameters, which can vary during bonding, are detected for assessing the quality of the bond and/or for influencing the bonding, wherein
- during the time period of bonding procedures, measurement signals of a plurality of parameters are recorded by means of sensors and are respectively provided as a temporal actual profile,
- one or a plurality of actual profiles of variables derived from the parameters are formed from measurement signals of a plurality of parameters of the bonding process,
- one or a plurality of actual profiles is/are respectively subjected to a computing operation, in particular a comparing operation, with a desired profile which is stored in a memory (IV) and is associated with the respective actual profile in relation to the parameter thereof or the derived variable thereof, wherein a deviation profile is determined in each case with respect to the actual profiles, in particular by comparison of individual values of actual and desired profiles which are temporally associated with one another, wherein a confidence interval of a specific magnitude about the distribution maximum is predetermined for the desired profile on the basis of a statistical model at the respective scanning times, wherein in the respective distributions the values at the lower interval boundary and/or upper interval boundary are determined, wherein a lower characteristic boundary curve profile is formed from the values of the lower interval boundary and/or an upper characteristic boundary curve profile is formed from the values of the upper interval boundary, and wherein the actual profiles determined during the production of bonded connections are arithmetically compared with the lower and/or upper characteristic boundary curve,
- an individual quality index Qi and/or a quality index Q collectively characterising the quality of an individual bonding procedure or individual bonded connection is respectively calculated by means of suitable computational means from one or a plurality of deviation profiles and is used for controlling or regulating subsequent bonding processes, **characterised in that**
- the plurality of parameters include at least one speed of the tool tip and a generator voltage, and
- the plurality of actual profiles of variables derived from the parameters comprise at least the mechanical admittance as a quotient of the two measurement variables of tool speed and generator voltage, and
- during the calculation, one or a plurality of deviation profiles are variably weighted temporally or in terms of their profile or in relation to the different elements of the deviation vector.

2. Method as claimed in claim 1, **characterised in that** the desired profiles are either fixedly preset or have been previously determined in a learning phase.

3. Method as claimed in claim 1 or 2, **characterised in that** one or a plurality of deviation profiles, in particular weighted independently of one another and/or temporally weighted, and/or one or a plurality of quality indices Qi and/or the quality index Q is/are used for controlling or regulating a currently proceeding bonding procedure and/or subsequent bonding procedures.

4. Method as claimed in claim 2, **characterised in that**
- a learning phase is carried out for at least one specific bonding reference system, with predetermination of specific settings of the bonding apparatus, in particular associated with the bonding reference system in a database, wherein the learning phase comprises a specific collective of learning bonding procedures,
- during the time of learning bonding procedures, measurement signals of one or, in a time-parallel manner, a plurality of parameters of the bonding process, such as in particular current intensity and/or voltage at the ultrasonic generator and/or wire deformation and/or ultrasonic frequency or resonant frequency and/or tool speed in the direction of oscillation, are recorded in each case by means of sensors and are respectively kept in a memory as, in particular, temporal learning profiles, and
- for at least one parameter, the probability density function or the relative probability of the measurement signal values is determined from the collective of the learning bonding procedures for points in time or measuring steps which are in each case constant or the same but are different or taken into consideration in the learning profiles.

5. Method as claimed in claim 4, **characterised in that**
- for the production of bonded connections or during automatic operation for a bonding reference system, the desired profiles created for this purpose during a learning phase are provided,
- during the time period of bonding procedures, measurement signals of one or a plurality of parameters are recorded in each case by means of sensors and respectively kept in a memory as actual profiles, and, for at least one parameter, a deviation profile is determined from the actual profile thereof and the desired profile determined therefor in the learning phase.

6. Method as claimed in any one or several of preceding claims 4 and 5, **characterised in that** the deviation profile is used for controlling or regulating the current and/or subsequent bonding procedures.

7. Method as claimed in any one of claims 1 to 6, **characterised in that** during the time period of bonding procedures, measurement signals of one or a plurality of further parameters, at least comprising the current intensity and/or voltage at the ultrasonic generator or transducer and/or wire deformation and/or ultrasonic frequency or resonant frequency, are recorded by means of sensors and are respectively provided as a temporal actual profile.

8. Bonding apparatus, in particular an ultrasonic wire bonding apparatus, for the production and quality control of ultrasonic bonded connections, having an ultrasonic generator, a transducer and a bonding tool, in particular a wedge, as well as a plurality of sensors for detecting measurement signals, in particular in real time, of various parameters which can vary during bonding, wherein the bonding apparatus has a signal processing unit (I) and has means, which are a component of the signal processing unit (I), for generating and providing actual profiles of individual parameters and/or variables derived therefrom, wherein the actual profiles are associated with measurement values from one or a plurality of bonding procedures,
- the bonding apparatus has a memory (IV), in which desired profiles relating to parameters and/or derived variables are stored,
- the bonding apparatus has an assessment unit (II) which is connected to the memory (IV) as well as to the sensors and/or the signal processing unit (I) and which determines deviation profiles, and from them individual quality indices Qi, for one or a plurality of selected parameters and/or derived variables separately from actual profiles and from desired profiles of the same parameters or derived variables,
- the bonding apparatus has a calculating unit (III) which is connected to the assessment unit (II) and which calculates a quality index Q from one or a plurality of individual quality indices Qi, **characterised in that** the bonding apparatus is suitably designed for carrying out the method as claimed in any one or several of claims 1 to 3, and:
- the parameters which can vary during the bonding comprise at least the speed of the tool tip in the direction of oscillation thereof and the generator voltage,
- the signal processing unit (I) prepares parameter sensor data and determines derived variables, at least comprising the mechanical admittance as a quotient of the two measurement variables of tool speed and generator voltage, from the parameters.

9. Bonding apparatus as claimed in claim 8, **characterised in that** the assessment unit (II) has means for profile-related weighting of the deviation profiles during the calculation of the individual quality indices Qi.

10. Bonding apparatus as claimed in any one or several of preceding claims 8 and 9, **characterised in that** the bonding apparatus has a controlling device or a regulating device for controlling or regulating the bonding process, the assessment unit (II) and/or the calculating unit (III) is connected to the controlling device or regulating device of the bonding apparatus for the transmission of data, in particular of deviation profiles weighted independently of one another and/or temporally weighted, and/or of individual quality indices Qi and/or the quality index Q, and the controlling or regulating unit uses the transmitted data for controlling or regulating the bonding process, in particular for influencing the bonding force and/or the ultrasonic power and/or the bonding time as manipulated variables.

11. Bonding apparatus as claimed in any one of claims 8 to 10, **characterised in that** the bonding apparatus has means, in particular comprising a computer with software which are suitable for carrying out a method as claimed in any one or several of preceding method claims 1 to 17 or are adapted for carrying out said method,
- the assessment unit (II) is suitable or adapted for combining individual quality indices Qi to form bond index groups,
- the bonding apparatus has a memory in which memory index groups and data separately linked thereto, particularly data concerning specific operating states of the bonding apparatus and particularly data concerning causes of error, are stored,
- the apparatus comprises a classification module which has a comparison module which is suitable for or adapted for a comparative association of bond index groups with memory index groups using preset similarity criteria, and for an output of the data or information linked in a memory with such memory index groups which satisfy at least one similarity criterion, in particular by means of software suitable for the purpose.

12. Bonding apparatus as claimed in claim 11, **characterised in that** the bonding apparatus has a monitoring unit which has a comparison module which is adapted for a comparison of bond index groups with memory index groups, particularly by means of suitable software and using similarity criteria, for the detection of outlier bond index groups which do not satisfy any similarity criteria, or satisfy only specific similarity criteria, and the monitoring unit is connected to the assessment unit II and/or the calculating device (III) for providing feedback of the results into the quality calculation.

13. Bonding apparatus as claimed in any one or several of preceding claims 11 and 12, **characterised in that**, for retroactively influencing, in particular in real time, the current bonding procedure or subsequent bonding procedures, the assessment unit (II) and/or the calculating device (III) and/or the classification model is connected for signal or data transmission to a controlling device or regulating device of the bonding apparatus which acts upon one or a plurality of manipulated variables, particularly upon the bonding force and/or the ultrasonic power and/or the bonding time.

## Revendications

1. Procédé de contrôle de qualité lors du soudage par ultrasons, dans lequel une unité transducteur-outil de soudage et un générateur d'ultrasons sont utilisés et dans lequel sont détectés, pendant le soudage, des signaux de mesure de plusieurs paramètres variables pendant le soudage afin d'évaluer la qualité du soudage et/ou d'agir sur elle, dans lequel
- pendant la durée des opérations de soudage, des signaux de mesure de plusieurs paramètres sont enregistrés au moyen de capteurs et sont respectivement fournis sous forme de courbe effective temporelle,
- une ou plusieurs courbes effectives sont formées de grandeurs dérivées des paramètres à partir de signaux de mesure de plusieurs paramètres du processus de soudage,
- une ou plusieurs courbes effectives sont soumises respectivement à une opération de calcul, en particulier à une opération de comparaison, avec une courbe de consigne mémorisée dans une mémoire (IV) associée à la courbe effective respective par rapport à son paramètre ou à sa grandeur dérivée, une courbe de déviation étant déterminée respectivement pour les courbes effectives, en particulier en comparant les valeurs individuelles associées temporellement des courbes effectives et de consigne, un intervalle de confiance de grandeur déterminée autour du maximum de répartition étant prédéterminé pour la courbe de consigne sur la base d'un modèle statistique par rapport aux moments d'échantillonnage respectifs, les valeurs étant déterminées dans les différentes répartitions au niveau de la frontière d'intervalle inférieure et/ou supérieure, une courbe caractéristique de frontière inférieure étant formée à partir des valeurs de la frontière d'intervalle inférieure et/ou une courbe caractéristique de frontière supérieure étant formée à partir des valeurs de la frontière d'intervalle supérieure, et les courbes effectives déterminées lors de la production de liaisons par soudage étant comparées par calcul à la courbe caractéristique de frontière inférieure et/ou supérieure,
- respectivement un indice de qualité individuel Qi et/ou un indice de qualité Q globalement caractérisant respectivement la qualité d'une opération de soudage individuelle ou d'une liaison par soudage individuelle est calculé au moyen de moyens de calcul appropriés à partir d'une ou de plusieurs courbes de déviation et est utilisé pour la commande et la régulation de processus de soudage ultérieurs, **caractérisé en ce que**
- plusieurs paramètres comprennent au moins une vitesse de la pointe d'outil et une tension du générateur et
- plusieurs courbes effectives de grandeurs dérivées des paramètres comprennent au moins l'admittance mécanique sous forme de quotient des deux grandeurs de mesure vitesse d'outil et tension de générateur et
- pendant le calcul, une ou plusieurs courbes de déviation sont pondérées de manière variable dans le temps ou dans leur allure ou par rapport aux divers éléments du vecteur de déviation.

2. Procédé selon la revendication 1, **caractérisé en ce que** soit les courbes théoriques sont prédéfinies de manière fixe, soit elles ont été déterminées préalablement dans une phase d'apprentissage.

3. Procédé selon la revendication 1 ou 2, **caractérisé en ce qu'**une ou plusieurs courbes de déviation en particulier pondérées indépendamment entre elles et/ou pondérées en fonction du temps et/ou un ou plusieurs indices de qualité Qi et/ou l'indice de qualité Q sont utilisés pour la commande ou la régulation d'une opération de soudage en cours et/ou d'opérations de soudage ultérieures.

4. Procédé selon la revendication 2, **caractérisé en ce que**
- une phase d'apprentissage est mise en oeuvre pour au moins un système de référence de soudage déterminé compte tenu de réglages déterminés du dispositif de soudage associés en particulier au système de référence de soudage, la phase d'apprentissage comprenant un ensemble déterminé d'opérations de soudage d'apprentissage,
- pendant la durée d'opérations de soudage d'apprentissage respectivement des signaux de mesure d'un ou de plusieurs paramètres en simultané du processus de soudage, comme en particulier l'intensité du courant et/ou la tension au niveau de générateur d'ultrasons et/ou la déformation du fil et/ou la fréquence d'ultrasons ou la fréquence de résonance et/ou la vitesse de l'outil dans la direction d'oscillation, sont enregistrés au moyen de capteurs et sont conservés en particulier sous forme d'opérations d'apprentissage temporelles dans une mémoire, et
- la fonction de densité de probabilité est déterminée à partir de l'ensemble des opérations de soudage d'apprentissage ou de la probabilité relative des valeurs de signal de mesure pour au moins un paramètre pour des moments respectivement constants ou égaux différenciés ou considérés dans les opérations d'apprentissage.

5. Procédé selon la revendication 4, **caractérisé en ce que**
- pour la production de liaisons par soudage ou en mode automatique pour un système de référence de soudage, les courbes de consigne établies à cette fin pendant une phase d'apprentissage sont fournies,
- pendant la durée d'opérations de soudage, des signaux de mesure d'un ou plusieurs paramètres sont respectivement enregistrés au moyen de capteurs et sont conservés respectivement sous forme de courbes effectives dans une mémoire, et qu'une courbe de déviation est déterminée pour au moins un paramètre à partir de sa courbe effective et de la courbe de consigne déterminée à cet effet dans la phase d'apprentissage.

6. Procédé selon une ou plusieurs des revendications précédentes 4 et 5, **caractérisé en ce que** la courbe de déviation est utilisée pour la commande ou la régulation d'une opération de soudage en cours et/ou d'opérations de soudage ultérieures.

7. Procédé selon l'une des revendications 1 à 5, **caractérisé en ce que** des signaux de mesure d'un ou plusieurs paramètres supplémentaires comprenant au moins l'intensité du courant et/ou la tension au niveau du générateur d'ultrasons ou du transducteur et/ou la déformation du fil et/ou la fréquence d'ultrasons ou la fréquence de résonance sont enregistrés au moyen de capteurs pendant la durée d'opérations de soudage et sont fournis sous forme de courbe effective temporelle.

8. Dispositif de soudage, en particulier dispositif de soudage de fil par ultrasons, pour produire et pour contrôler la qualité de liaisons par soudage par ultrasons, présentant un générateur d'ultrasons, un transducteur et un outil de soudage, en particulier un outil de soudage à chaud, ainsi que plusieurs capteurs pour la détection de signaux de mesure, en particulier en temps réel, de différents paramètres variables pendant le soudage, dans lequel le dispositif de soudage présente une unité de traitement de signaux (I), et présente des moyens qui sont des éléments constitutifs de l'unité de traitement des signaux (I), pour générer et fournir des courbes effectives de différents paramètres et/ou de grandeurs dérivées, les courbes effectives étant associées à des valeurs de mesure provenant d'une ou plusieurs opérations de soudage,
- le dispositif de soudage présente une mémoire (IV), dans laquelle sont sauvegardées des courbes de consigne pour les paramètres et/ou grandeurs dérivées,
- le dispositif de soudage présente une unité d'évaluation (II), qui est reliée à la mémoire (IV) ainsi qu'aux capteurs et/ou à l'unité de traitement de signaux (I) et qui détermine des courbes de déviation et à partir de celles-ci des indices de qualité individuels Qi pour un ou plusieurs paramètres sélectionnés et/ou grandeurs dérivées séparément à partir de courbes effectives et de courbes de consigne de mêmes paramètres ou de grandeurs dérivées,
- le dispositif de soudage présente une unité de calcul (III), qui est reliée à l'unité d'évaluation (II) et qui calcule un indice de qualité Q à partir d'un ou plusieurs indices de qualité individuels Qi, **caractérisé en ce que** le dispositif de soudage est réalisé de manière appropriée pour la mise en oeuvre du procédé selon l'une ou plusieurs des revendications 1 à 3 et :
- les paramètres variables pendant le soudage comprennent au moins la vitesse de la pointe d'outil dans sa direction d'oscillation et la tension de générateur,
- l'unité de traitement des signaux (I) traite des données de capteur de paramètres et détermine à partir des paramètres des grandeurs dérivées comprenant au moins l'admittance mécanique sous forme de quotient des deux grandeurs de mesure vitesse d'outil et tension de générateur.

9. Dispositif de soudage selon la revendication 8, **caractérisé en ce que** l'unité d'évaluation (II) présente un moyen pour pondérer les courbes de déviation lors du calcul des indices de qualité individuels Qi.

10. Dispositif de soudage selon une ou plusieurs des revendications précédentes 8 et 9, **caractérisé en ce que** le dispositif de soudage présente un moyen de commande ou un moyen de régulation pour commander ou régler le processus de soudage, l'unité d'évaluation (II) et/ ou l'unité de calcul (III) est reliée au moyen de commande ou de régulation du dispositif de soudage pour la transmission de données, en particulier de courbes de déviation pondérées indépendamment les unes des autres et/ou pondérées en fonction du temps et/ou d'indices de qualité individuels Qi et/ou de l'indice de qualité Q, et que l'unité de commande ou de régulation utilise les données transmises pour la commande ou la régulation du processus de soudage, en particulier pour influencer la force de soudage et/ou la puissance des ultrasons et/ou du temps de soudage sous forme de grandeurs de réglage.

11. Dispositif de soudage selon l'une des revendications 8 à 10, **caractérisé en ce que** le dispositif de soudage présente des moyens, en particulier comprenant un ordinateur avec logiciel, qui sont appropriés à la mise en oeuvre d'un procédé selon une ou plusieurs revendications de procédé précédentes 1 à 7 ou adaptés à sa réalisation,
- l'unité d'évaluation (II) est appropriée ou est adaptée pour regrouper des indices de qualité individuels Qi en groupes d'indices de soudage,
- le dispositif de soudage présente une mémoire dans laquelle des groupes d'indices de la mémoire et des données liées séparément à ces derniers, en particulier des données par rapport à certains états de fonctionnement du dispositif de soudage et en particulier des données par rapport aux causes de défaillance, sont sauvegardés,
- le dispositif comprend un module de classification qui présente un module de comparaison, qui est approprié ou adapté à une association comparative de groupes d'indices de soudage à des groupes d'indices de la mémoire en utilisant des critères de similarité prédéfinis et à une émission des données ou d'informations liées dans une mémoire à de tels groupes d'indices de la mémoire qui répondent au moins à un critère de similarité, en particulier au moyen d'un logiciel adapté.

12. Dispositif de soudage selon la revendication 11, **caractérisé en ce que** le dispositif de soudage comprend une unité de surveillance, qui présente un module de comparaison, qui est adapté, en particulier au moyen d'un logiciel approprié en utilisant des critères de similarité, à une comparaison de groupes d'indices de soudage avec des groupes d'indices de la mémoire pour la détection de groupes d'indices de soudage de valeurs aberrantes, qui ne répondent à aucun ou seulement à certains critères de similarité définis, et que l'unité de surveillance pour la rétroaction des résultats dans le calcul de qualité est reliée à l'unité d'évaluation (II) et/ou au moyen de calcul (III).

13. Dispositif de soudage selon une ou plusieurs des revendications précédentes 11 et 12, **caractérisé en ce que**, pour influencer rétroactivement, en particulier en temps réel, l'opération de soudage actuel ou les opérations de soudage ultérieures, l'unité d'évaluation (II) et/ou le moyen de calcul (IR) et/ou le modèle de classification est reliée, pour la transmission des signaux ou des données, à un moyen de commande ou à un moyen de régulation du dispositif de soudage, qui agit sur une ou plusieurs grandeurs de réglage, en particulier sur la force de soudage et/ou la puissance des ultrasons et/ou le temps de soudage.
